# EUROPÄISCHE PATENTSCHRIFT

(11) **EP 3 858 766 B1**
(45) Veröffentlichungstag und Bekanntmachung des Hinweises auf die Patenterteilung: **06.05.2026**
(21) Anmeldenummer: 20155166.0
(22) Anmeldetag: 03.02.2020
(51) Int. Cl.: B65G 47/14, B23P 19/00, H05K 13/02

(54) **ZUFUHRVORRICHTUNG SOWIE EIN HERSTELLUNGSVERFAHREN UND EIN BETRIEBSVERFAHREN FÜR DIE ZUFUHRVORRICHTUNG**
FEEDING DEVICE AND MANUFACTURING METHOD AND OPERATING METHOD FOR THE FEEDING DEVICE
DISPOSITIF D'ALIMENTATION AINSI QUE PROCÉDÉ DE FABRICATION ET PROCÉDÉ DE FONCTIONNEMENT POUR LE DISPOSITIF D'ALIMENTATION

(43) Veröffentlichungstag der Anmeldung: 04.08.2021
(73) Patentinhaber: Böllhoff Verbindungstechnik GmbH, 33649 Bielefeld (DE)
(72) Erfinder: BERGER, Nadja, 33604 Bielefeld (DE); WESTERMANN, Wilhelm, 33719 Bielefeld (DE); VORNHEDER, Matthias, 32289 Rödinghausen (DE); DRAHT, Torsten Dr., 33758 Schloß Holte-Stukenbrock (DE)
(74) Vertreter: HWP Intellectual Property

(56) Entgegenhaltungen:
- GB-A- 1 074 630
- JP-A- S58 104 812
- KR-B1- 100 769 711
- US-A- 2 774 519
- US-A- 3 305 067
- US-A1- 2010 140 287

## Beschreibung

### 1. Gebiet der Erfindung

Die vorliegende Erfindung betrifft eine Zufuhrvorrichtung, mit der Elemente in ungeordneter Form, die Verbindungselemente als Schüttgut sind, einem Aufnahmevolumen zuführbar sind. Des Weiteren beschreibt vorliegende Anmeldung einen nicht beanspruchten Nachrüstsatz für einen Vibrationsförderer, so dass Elemente in ungeordneter Form, insbesondere Verbindungselemente als Schüttgut, einem zweiten Aufnahmevolumen gebildet durch den Vibrationsförderer zuführbar sind. Zudem beschreibt vorliegende Anmeldung ein Herstellungsverfahren für eine derartige Zufuhrvorrichtung sowie ein Zufuhrverfahren für eine Mehrzahl ungeordneter Elemente, insbesondere Verbindungselemente als Schüttgut, mithilfe der Zufuhrvorrichtung.

### 2. Hintergrund der Erfindung

Im Stand der Technik werden Verbindungselemente automatisiert verarbeitet. Zu diesen Verbindungselemente zählen beispielsweise Halbhohlstanzniete, Vollstanzniete, Gewindebolzen, Nägel, Schussbolzen, Blindnietmuttern, Einpressmuttern und ähnliche Konstruktionen, mit denen sich mehrere Lagen von Bauteilen miteinander verbinden lassen.

Bevor diese Verbindungselemente durch beispielsweise ein Setzgerät für Stanzniete oder ein Setzgerät für Blindnietmuttern verarbeitet werden, werden sie als Schüttgut über eine Zufuhrvorrichtung dem verarbeitenden Setzgerät zugeführt. Dabei sorgt die Zufuhrvorrichtung generell dafür, dass aus den als Schüttgut vorliegenden Verbindungselementen im Verlauf des Zufuhrwegs Verbindungselemente vereinzelt werden, sodass diese dann einzeln durch das Setzgerät zum Herstellen einer Verbindung verarbeitet werden können.

Für derartige Zufuhrvorrichtungen sind im Stand der Technik verschiedene Konstruktionen und damit verbundene Verarbeitungsprinzipien bekannt.

In JP 2015-063370 A, US 2012/0257951 A1 und in JP 2001 287 826 A reguliert ein Rad die Zahl der abgegebenen Elemente an der Auslassöffnung eines Aufnahmebehälters.

KR 10-130 9643 nutzt ein verstellbares Sperrelement innerhalb des Aufnahmebehälters der Verbindungselemente. Das Sperrelement verkleinert oder vergrößert eine Öffnung, durch welche die Verbindungselemente bzw. Elemente aufgrund ihrer Schwerkraft, also gravitationsgetrieben, hindurch fallen.

In den Dokumenten KR 10-2012-0121523, EP 2 331 434 B1, DE 10 2007 016 691 A1 sowie US 2,774,519 verschließt eine versetzbare Tür die Auslassöffnung des Aufnahmebehälters. Entsprechend lässt sich über die Öffnungsgröße der Auslassöffnung die Anzahl der von dem Aufnahmebehälter abgegebenen Elemente einstellen.

In US 2,065,319 wird die Auslassöffnung eines trichterförmigen Aufnahmebehälters mit Elementen durch eine Art Schale begrenzt und blockiert. Entsprechend stehen aufgrund des Staudrucks der Elemente diese an einem Übergabespalt an, der zwischen dem trichterförmigen Behälter und der Schale vorhanden ist. Aufgrund eines Absatzes in der Schale werden die Elemente nicht ungehindert aus dem trichterförmigen Aufnahmebehälter in die Schale gedrückt. Vielmehr werden die an der Schale aufgestauten Elemente durch einen Abstreifmechanismus in begrenzter Anzahl regelmäßig abgeführt. Dieser Abstreifmechanismus bewegt sich an den aufgestauten Elementen auf der Schale vorbei. Da der Abstreifmechanismus um den trichterförmigen Aufnahmebehälter dreht und auf diese Weise in einer regelmäßigen Abstreifbewegung an den aufgestauten Elementen vorbeigeführt wird, werden die Elemente kontinuierlich aus dem aufgestauten Bereich zwischen dem Aufnahmebehälter und der Schale abgeführt.

Gemäß der in US 2,896,824 beschriebenen Zufuhrvorrichtung dient ein Aufnahmebehälter zum Speichern von Elementen als Schüttgut. Die Auslassöffnung am Boden des Aufnahmebehälters ist durch einen Teller verschlossen, der sich radial über die Außenwand des Aufnahmebehälters hinaus erstreckt. Da zwischen dem Teller und dem benachbarten Rand des Aufnahmebehälters ein Übergabespalt vorhanden ist, können die im Aufnahmebehälter gestauten Elemente durch den Übergabespalt aus dem Aufnahmebehälter auf den Teller gelangen. Zur Unterstützung der Übergabe der Elemente von dem Aufnahmebehälter an den Teller werden der Aufnahmebehälter und der Teller über eine gemeinsame Drehachse gemeinsam gedreht. Entsprechend unterstützen wirkende Fliehkräfte die Übergabe der Elemente durch den Übergabespalt zwischen dem Aufnahmebehälter und dem Teller. Von dem sich drehenden Teller werden die Elemente dann mithilfe einer Bürstenanordnung in kontrollierter Anzahl abgeführt.

Eine Vorrichtung zum Zuführen relativ großer Artikel, die aus einem festen Material bestehen, aus einem Behälter mit einer unteren Abgabeöffnung zu einer Wiege-, Zähl- oder ähnlichen Vorrichtung ist in US 3,305,067 A beschrieben. Die Vorrichtung umfasst eine einheitliche Troganordnung mit fester Position mit einem Zufuhrabschnitt, der angeordnet ist, um Artikel in zufälliger Anordnung aus dem Behälter aufzunehmen, und einem Abgabeabschnitt, der so angeordnet ist, dass er Artikel von dem Zufuhrbschnitt aufnimmt und abtransportiert. Weiterhin umfasst die Vorrichtung Mittel zum Übermitteln einer Bewegung von oberen Artikeln entlang der Anordnung, Mittel zum Reduzieren der Tiefe des Körpers der Artikel auf dem Zufuhrabschnitt auf die Tiefe eines einzelnen Artikels, Mittel, die eine Verbindungsstelle einer vorgegebene Kontur zwischen den benachbarten Enden der Zufuhr- und Abgabeabschnitte definieren, sowie Oberflächenmittel, die auf dem Abgabeabschnitt gebildet sind und mit der Verbindungsstelle zusammenwirken, um die zeitlich abgestimmte Ankunft der zufällig angeordneten Artikel in einer einzigen Reihe mit der Tiefe eines einzelnen Artikels zu ermöglichen, während sie sich entlang des Abgabeabschnitts bewegen. US 3,305,067 A offenbart die Merkmale des Oberbegriffs von Patentanspruch 1.

KR 10-0769711 B1 beschreibt eine Muttern-Zuführvorrichtung für eine Schweißmaschine, und ein Muttern-Zuführtrichter zum Zuführen einer Mutter, der innerhalb einer Mutternausrichtvorrichtung zum Sortieren und Ausrichten der zugeführten Mutter so installiert ist, dass sie sich auf der Oberseite der Mutternausrichtvorrichtung befindet. Der Zweck besteht darin, das Volumen und das Gewicht der Muttern-Zuführvorrichtung deutlich zu reduzieren, indem sichergestellt wird, dass die Muttern zu jeder Zeit kontinuierlich zugeführt werden. Aus diesem Grund sind ein Rüttler auf dem oberen Teil der Basis, die die untere Struktur bildet, ein Mutternsortierer auf dem oberen Teil des Rüttlers, um die darin zugeführte Mutter durch Vibration auszurichten, und ein Mutternzufuhrtrichter zum Zuführen von einer Mutter in das Innere des Mutternsortierers installiert. Weiterhin ist ein Mutternführungsrohr zum Transportieren und Zuführen der durch die Mutternausrichtvorrichtung ausgerichteten Mutter zu der Mutternzuführung in regelmäßigen Abständen bereitgestellt, wobei der Mutternzufuhrtrichter in regelmäßigen Abständen an einem oberen Abschnitt der Mutternausrichtvorrichtung installiert ist. Zusätzlich ist ein Muttern-Aufbewahrungsbehälter in Form eines Zylinders mit offenem Boden vorhanden sowie eine erste Führungsplatte in Form eines Bogens, die in der Form einer nach unten geneigten Fläche von einer Seite der Innenfläche des Muttern-Aufbewahrungsbehälters zur Mitte hin installiert und befestigt ist, so dass der Vorrat der darin gelagerten Muttern an der anderen Seite entlang der geneigten Fläche zugeführt wird. Diese ist in Form einer nach unten geneigten Fläche in der Mittelrichtung von der Innenfläche des Mutternaufbewahrungsbehälters auf der anderen Seite, die die gegenüberliegende Fläche der ersten Führungsplatte ist, installiert und befestigt und führt die Mutter entlang der geneigten Oberfläche der ersten Führungsplatte zum unteren Teil des Muttern-Aufbewahrungsbehälters. Das untere Ende der zweiten Führungsplatte ist so installiert, dass es von dem unteren Ende der geneigten Fläche der ersten Führungsplatte um einen vorbestimmten Abstand beabstandet ist, und ein Reservoirstützmittel zum Stützen und Fixieren des Muttern-Reservoirs ist vorgesehen, um in einem vorbestimmten Intervall auf dem oberen Abschnitt des Mutternausrichters installiert zu werden.

Eine Vorrichtung zum Zuführen von Artikeln zu einer Maschine, z.B. kurze Drähte oder Stäbe, die Niet- oder Kontaktrohlinge für eine Vortriebsmaschine bilden, ist in GB 1 074 630 A beschrieben. Die Vorrichtung umfasst eine Vibrationszuführvorrichtung in Form eines kreisförmigen Behälters mit einer inneren spiralförmigen Führungsbahn, die sich vom Boden des Behälters zu einem Auslass erstreckt, der zur Maschine führt. Der Behälter wird aus einem Trichter mit einer seitlichen Auslaßöffnung versorgt, die mit einer angelenkten Schließklappe versehen ist, deren Position durch die Druckdifferenz zwischen den Artikel innerhalb des Trichters, die Druck auf die Innenseite der Klappe ausüben, und den im Behälter zirkulierenden Artikel bestimmt wird, die auf die Außenseite der Klappe Druck ausüben. Der Behälter ist mittels elastischer Streifen auf einer Basis montiert, die einen Block trägt, der einen Elektromagneten trägt und von dem sich nach oben Ständer erstrecken, die den Trichter tragen. Die Klappe kann aus Leichtmetall, Gummi oder Kunststoff bestehen.

Abschließend beschreibt JP S58-104812 A einen Trichter für einen virbierenden Teileförderer. Mittels des Trichters soll die Bildung einer Teilebrücke in der Nähe einer Austragsöffnung in einem vibrierenden Teileförderer verhindert werden, indem ein Trichter um seinen Wellenkern drehbar auf einem Bett oder teilweise auf einem Gebäude abgestützt wird. Der zentrale untere Teil eines schalenförmigen Behälters in einem vibrierenden Teileförderer ist konisch geformt, und eine Austragöffnung ist an einer gegenüberliegenden Position zu dem Teil angeordnet, um einen Trichter anzuordnen. Der Trichter wird durch Lagerblöcke mittels mehrerer Streben getragen, die an einem Bett befestigt sind. Gummielemente, die am unteren Endteil des Trichters befestigt sind, werden zwischen den Teilen gehalten, die in den Elementen und außerhalb davon vorhanden sind. Weitere Reibungskraft wird zwischen dem Element und dem Teil erzeugt, und der Trichter wird mit einer Übertragungskraft der Teile beaufschlagt und in diese Richtung gedreht. Auf diese Weise kann das Teil problemlos aus dem Trichter ausgetragen werden, ohne dass ein Überbrückungsphänomen verursacht wird.

Die im Stand der Technik bekannten Konstruktionen von Zufuhrvorrichtungen und die damit realisierten Zufuhrverfahren sind zumeist auf bestimmte Elementgeometrien abgestimmt. Daher lassen sie sich nicht ohne weiteres auf andere Elementgeometrien übertragen.

Es ist daher die Aufgabe vorliegender Erfindung, eine alternative Zufuhrvorrichtung für Elemente vorzuschlagen, die zur Verarbeitung von Verbindungselementen, wie Stanzniete, Blindnietmuttern, Bolzen und dergleichen geeignet sind und die Zufuhr von Verbindungselementen zunächst als Schüttgut und dann in reduzierter Anzahl zu gewährleisten.

### 3. Zusammenfassung der Erfindung

Die obige Aufgabe wird durch eine Zufuhrvorrichtung gemäß dem unabhängigen Patentanspruch 1 gelöst, mit der Elemente in ungeordneter Form, die Verbindungselemente als Schüttgut sind, einem zweiten Aufnahmevolumen zuführbar sind. Eine weitere Lösung obiger Aufgabe stellt ein nicht beanspruchter Nachrüstsatz für einen Vibrationsförderer dar, mit dem Elemente in ungeordneter Form, insbesondere Verbindungselemente als Schüttgut, einem zweiten Aufnahmevolumen gebildet durch den Vibrationsförderer zuführbar sind. Des Weiteren stellt ein Herstellungsverfahren für obige Zufuhrvorrichtung gemäß dem unabhängigen Patentanspruch 8 sowie ein Zufuhrverfahren für eine Mehrzahl ungeordneter Elemente mithilfe der oben genannten Zufuhrvorrichtung gemäß dem unabhängigen Patentanspruch 9 ebenfalls eine Lösung der oben gestellten Aufgabe dar. Vorteilhafte Ausgestaltungen und Weiterentwicklungen vorliegender Erfindung gehen aus den abhängigen Patentansprüchen, der folgenden Beschreibung sowie den begleitenden Zeichnungen hervor.

Mit der erfindungsgemäßen Zufuhrvorrichtung sind Elemente in ungeordneter Form, insbesondere Verbindungselemente als Schüttgut, einem zweiten Aufnahmevolumen zuführbar. Die Zufuhrvorrichtung weist die folgenden Merkmale auf: einen ersten Aufnahmebehälter, der, insbesondere durch eine erste umlaufende Außenwand, ein erstes Aufnahmevolumen für die ungeordneten Elemente definiert, welches über eine erste Zufuhröffnung, vorzugsweise in dem ersten Aufnahmebehälter, befüllbar und über eine erste Auslassöffnung, vorzugsweise in dem ersten Aufnahmebehälter, entleerbar ist, einen zweiten Aufnahmebehälter, der, insbesondere über eine zweite umlaufende Außenwand, das zweite Aufnahmevolumen definiert, wobei der erste Aufnahmebehälter mit dem ersten Aufnahmevolumen zumindest teilweise innerhalb des zweiten Aufnahmevolumens angeordnet ist, ein Boden des zweiten Aufnahmebehälters derart beabstandet zur ersten Auslassöffnung positioniert ist, dass der Boden das erste Aufnahmevolumen begrenzt und eine Übergabezone für ungeordnete Elemente vom ersten Aufnahmebehälter in den zweiten Aufnahmebehälter vorhanden ist, und wobei zumindest der Boden, insbesondere eine Innenwand, des zweiten Aufnahmebehälters in Bezug auf den ersten Aufnahmebehälter derart bewegbar ist, dass die ungeordneten Elemente durch die Bewegung des Bodens aus dem ersten Aufnahmevolumen des ersten Aufnahmebehälters in das zweite Aufnahmevolumen des zweiten Aufnahmebehälters abführbar sind.

Die vorliegende Erfindung verändert die automatische Dosierung der zuzuführenden Elemente, um den Zufuhrprozess zu vereinfachen. Zu diesem Zweck wird eine stufenweise und/oder kontinuierliche Zufuhr der Elemente zu vorzugsweise einem Vibrationsförderer oder einem Vibrationswendelförderer genutzt, anstatt die vollständige Menge an Elementen in einem Schritt an den Vibrationsförderer zu übergeben.

Während der bevorzugte Vibrationsförderer, insbesondere der Vibrationswendelförderer, einen zweiten Aufnahmebehälter für die Elemente als Schüttgut darstellt, ist als vorgelagerte Zufuhrstufe innerhalb oder angrenzend an den zweiten Aufnahmebehälter ein erster Aufnahmebehälter vorgesehen. Zwar enthält der erste Aufnahmebehälter ebenfalls ein mit Elementen gefülltes erstes Aufnahmevolumen, diese Anzahl an Elementen ist aber nur gesteuert durch eine Übergabezone aus dem ersten Aufnahmebehälter in den zweiten Aufnahmebehälter überführbar. Dadurch ist bevorzugt die durch den zweiten Aufnahmebehälter, vorzugsweise ein Vibrationswendelförderer, aufzunehmende und zu verarbeitende Menge an Elementen dosierbar und zumeist kleiner als im Stand der Technik. Auf diese Weise ist aber nicht die Verarbeitungsrate des zweiten Aufnahmebehälters reduziert, die eine Abfuhr einer bestimmten Anzahl an Elementen aus dem zweiten Aufnahmebehälter, insbesondere dem Vibrationswendelförderer, umfasst und gewährleisten soll.

Zudem ist mit dieser gesteuerten Zufuhr von Elementen eine geringere Lärmbelästigung durch die Zufuhrvorrichtung verbunden. Denn vorzugsweise dient der erste Aufnahmebehälter als Elementspeicher, von dem gleichmäßig Elemente an den zweiten Aufnahmebehälter abführbar sind. Entsprechend ist es nicht erforderlich, in regelmäßigen Abständen größere Mengen an Elementen in den zweiten Aufnahmebehälter zu schütten.

Außerdem führt die verkleinerte bzw. dosierte Übergabemenge an ungeordneten Elementen vom ersten Aufnahmebehälter an den zweiten Aufnahmebehälter zu einem reduzierten Überwachungs- und Steuerungsaufwand. Dies hat zur Folge, dass weniger Sensoren in Kombination mit einer einfachen Zufuhrkonstruktion nutzbar sind.

Denn vorliegende Erfindung nutzt einen in Bezug auf den zweiten Aufnahmebehälter unbeweglich angeordneten ersten Aufnahmebehälter zur Elementspeicherung. Da der zweite Aufnahmebehälter, vorzugsweise mit seinem Boden oder allgemein seiner Innenwand, die Elementspeicherung im ersten Aufnahmevolumen des ersten Aufnahmebehälters und damit das erste Aufnahmevolumen selbst begrenzt, lässt sich eine Bewegung des zweiten Aufnahmebehälters relativ zum ersten Aufnahmevolumen und den darin enthaltenen Elementen nutzen, um eine gesteuerte Anzahl an Elementen aus dem ersten Aufnahmebehälter in den zweiten Aufnahmebehälter abzuführen. In diesem Zusammenhang wird das erste Aufnahmevolumen durch die erste umlaufende Außenwand und die Innenwand des zweiten Aufnahmebehälters definiert und begrenzt. Das gilt bevorzugt auch dann, wenn ein Abstand zwischen dem Boden und dem benachbarten Rand der umlaufenden Außenwand des ersten Aufnahmebehälters vorhanden ist. Neben der vom ersten Aufnahmebehälter entkoppelten Bewegung des zweiten Aufnahmebehälters steuert eine gezielte Dimensionierung oder konstruktive Durchlassgestaltung für Elemente der Übergabezone eine Anzahl zwischen den Aufnahmebehältern übertragener Elemente.

Gemäß einer bevorzugten Ausgestaltung der erfindungsgemäßen Zufuhrvorrichtung ist der Boden oder allgemein die Innenwand des zweiten Aufnahmebehälters mithilfe eines Antriebs in Schwingungen versetzbar, um die ungeordneten Elemente, insbesondere Verbindungselemente, aus dem ersten Aufnahmebehälter abzuführen.

Wie oben bereits beschrieben worden ist, begrenzt der zweite Aufnahmebehälter das erste Aufnahmevolumen an Elementen im ersten Aufnahmebehälter. Auf diese Weise wird einerseits bevorzugt die Übergabezone der ungeordneten Elemente zwischen dem ersten und dem zweiten Aufnahmebehälter festgelegt. Zudem erlaubt die Begrenzung des ersten Aufnahmevolumens durch den Boden des zweiten Aufnahmebehälters eine Übertragung einer Bewegung des Bodens auf die im ersten Aufnahmevolumen gespeicherten Elemente. Da gemäß einer bevorzugten Ausführungsform eine Schwingung oder Vibration des Bodens als Zufuhrunterstützung für die im ersten Aufnahmebehälter gespeicherten Elemente genutzt wird, führt diese Vibration oder allgemein diese Bewegung des Bodens oder allgemein der Innenwand des zweiten Aufnahmebehälters in Kombination mit dem Staudruck der ungeordneten Elemente innerhalb des ersten Aufnahmevolumens zu einer dosierten Übergabe von Elementen durch die Übergabezone von dem ersten Aufnahmebehälter in den zweiten Aufnahmebehälter. Neben einer Vibration beispielsweise durch die Nutzung eines bekannten Vibrationsförderers ist es ebenfalls bevorzugt, eine Schwingungsbewegungen oder eine Rotationsbewegung auf den Boden oder allgemein die Innenwand des zweiten Aufnahmebehälters zu übertragen, um Elemente aus dem ersten Aufnahmebehälter abzuführen.

Gemäß einer weiteren bevorzugten Ausgestaltung der erfindungsgemäßen Zufuhrvorrichtung werden in dem ersten Aufnahmebehälter die ungeordneten Elemente schwerkraftgetrieben, insbesondere passiv oder über ein inneres aktives Antriebsmittel im ersten Aufnahmebehälter, zur ersten Auslassöffnung transportiert.

Konstruktiv bevorzugt besteht der einfachste Aufbau des ersten Aufnahmebehälters aus einer im Wesentlichen zylindrisch oder anders geformten umlaufenden Außenwand. Innerhalb dieser nach außen begrenzenden Außenwand lässt sich das erste Aufnahmevolumen an ungeordneten Elementen speichern. Sofern der erste Aufnahmebehälter eine annähernd vertikale Ausrichtung aufweist, bewegt die wirkende Gravitationskraft bzw. die wirkende Schwerkraft der Elemente die Menge an ungeordneten Elementen von der ersten Zufuhröffnung in Richtung der ersten Auslassöffnung. Sollte jedoch der erste Aufnahmebehälter beispielsweise aufgrund eines begrenzten Platzangebots nur eine geneigte oder eine andersartige Ausrichtung oder unregelmäßige Form aufweisen, lassen sich ebenfalls durch ein inneres Transportmittel die ungeordneten Elemente in Richtung der ersten Auslassöffnung bewegen. Zu diesem Zweck ist beispielsweise ein inneres motorisch angetriebenes Förderrad oder -band einsetzbar.

Erfindungsgemäß weist die Außenwand des ersten Aufnahmebehälters angrenzend an die Auslassöffnung mindestens einen seitlichen Ausschnitt auf, der die Übergabezone definiert.

Aufgrund der benachbarten Anordnung des ersten Aufnahmebehälters, insbesondere der ersten Auslassöffnung, zu dem zweiten Aufnahmebehälter begrenzt dieser mit dem Boden und/oder seiner Innenwand das erste Aufnahmevolumen mit einer bestimmten Menge an ungeordneten Elementen. Um die Anzahl an ungeordneten Elementen zu kontrollieren, die aus dem ersten Aufnahmevolumen an das zweite Aufnahmevolumen des zweiten Aufnahmebehälters abgegeben werden, ist ein seitlicher Ausschnitt angrenzend an die Auslassöffnung des ersten Aufnahmebehälters vorgesehen. Die Größe des Ausschnitts ist derart gewählt, dass trotz eines möglichen Staudrucks der ungeordneten Elemente im ersten Aufnahmebehälter nur eine gesteuerte Anzahl an ungeordneten Elementen das erste Aufnahmevolumen in den zweiten Aufnahmebehälter verlassen kann.

Im Hinblick auf die zuvor beschriebene Ausgestaltung der Zufuhrvorrichtung ist es bevorzugt, den Boder oder die Innenwand des zweiten Aufnahmebehälters derart beabstandet zur Auslassöffnung, insbesondere deren Rand, des ersten Aufnahmebehälters anzuordnen, dass ungeordnete Elemente durch den seitlichen Ausschnitt, nicht aber durch einen Spalt zwischen der ersten Außenwand des ersten Aufnahmebehälters und dem Boden oder der Innenwand des zweiten Aufnahmebehälters abführbar sind.

Durch die bevorzugt gezielte Beabstandung des Randes der umlaufenden Außenwand des ersten Aufnahmebehälters zumindest zum Boden des zweiten Aufnahmebehälters wird bevorzugt gewährleistet, dass die ungeordneten Elemente nur über den seitlichen Ausschnitt das erste Aufnahmevolumen verlassen können. Dies eröffnet die Möglichkeit, dass über die Dimensionierung und auch über die Anordnung des seitlichen Ausschnitts die Anzahl der übergebenen ungeordneten Elemente und die Zufuhrrichtung der ungeordneten Elemente zum zweiten Aufnahmebehälter bestimmbar sind.

In diesem Zusammenhang ist es bevorzugt, dass der seitliche Ausschnitt der erfindungsgemäßen Zufuhrvorrichtung einen Öffnungswinkelbereich von 90° bis 180° bezogen auf eine Mittellängsachse des ersten Aufnahmebehälters abdeckt. Zudem ist es ebenfalls bevorzugt, den Winkelbereich des Ausschnitts auf 60°, 70° oder 80° zu begrenzen. Des Weiteren eröffnet die erfindungsgemäß bevorzugte Konstruktion der Zufuhrvorrichtung auch die Möglichkeit, eine Mehrzahl an seitlichen Ausschnitten für die Übergabe von ungeordneten Elementen aus dem ersten Aufnahmevolumen an den zweiten Aufnahmebehälter vorzusehen. In diesem Zusammenhang ist es bevorzugt, den oder die mehreren seitlichen Ausschnitte mit vorhandenen Zufuhrwegen des zweiten Aufnahmebehälters zum weiteren Transport der ungeordneten Elemente abzustimmen.

Erfindungsgemäß ist der seitliche Ausschnitt durch eine flexible Rückhaltevorrichtung, insbesondere eine flexible Bürstenanordnung oder ein elastischer Schlauch oder ein Vorhang, zumindest teilweise blockiert, wodurch die ungeordneten Elemente in der Übergabezone in einer verlangsamten Bewegung vom ersten Aufnahmebehälter an den zweiten Aufnahmebehälter zugeführt werden.

Gemäß einer bevorzugten Ausführungsform entscheidet allein die Dimensionierung des seitlichen Ausschnitts darüber, welche Anzahl an ungeordneten Elementen aus dem ersten Aufnahmevolumen an den zweiten Aufnahmebehälter übergeben werden. Neben der Dimensionierung des seitlichen Ausschnitts ist es ebenfalls bevorzugt, den seitlichen Ausschnitt durch die flexible Rückhaltevorrichtung, insbesondere gemäß einer Ausführungsform die flexiblen Borsten einer Bürstenanordnung, zu blockieren. Diese Rückhaltevorrichtung wirkt ähnlich einem Vorhang oder einer überwindenbaren Barriere, durch die ungeordnete Elemente bewegbar sind, sodass die ungeordneten Elemente die flexible Rückhaltevorrichtung überwinden können. Dabei bildet die flexible Rückhaltevorrichtung bevorzugt eine Bremse für die Zahl der ungeordneten Elemente, die aus dem ersten Aufnahmebehälter an den zweiten Aufnahmebehälter übergeben werden sollen. Entsprechend ist es bevorzugt, dass die Konstruktion der flexiblen Rückhaltevorrichtung, vorzugsweise eine Anzahl von Borsten der flexiblen Bürstenanordnung, aufgrund ihres Durchlassgrades die Anzahl an ungeordneten Elementen bestimmt, die aus dem ersten Aufnahmevolumen in den zweiten Aufnahmebehälter überführbar sind. Für die bevorzugte Durchlassrate der flexiblen Rückhaltevorrichtung ist beispielsweise die Dichte der den seitlichen Ausschnitt verschließenden Borsten der bevorzugten Bürstenanordnung, die Flexibilität der Borsten der Bürstenanordnung, das gewählte Material der Bürstenanordnung und die damit verbundene Reibung zwischen den ungeordneten Elementen und der Bürstenanordnung entscheidend. Diese Gestaltung von Eigenschaften ist analog auf andere bevorzugte Alternativen der flexiblen Rückhaltevorrichtung übertragbar.

Gemäß einer weiteren bevorzugten Ausgestaltung der Zufuhrvorrichtung ist die flexible Rückhaltevorrichtung positionsverstellbar in Bezug auf den seitlichen Ausschnitt des ersten Aufnahmebehälters angeordnet, um eine Größe einer Abdeckung des seitlichen Ausschnitts durch die flexible Rückhaltevorrichtung verändern zu können.

Die veränderbare Positionierung der flexiblen Rückhaltevorrichtung hat zur Folge, dass der seitliche Ausschnitt in einen Durchlassbereich ohne Behinderung durch die flexible Rückhaltevorrichtung und in einen weiteren Durchlassbereich mit einer Behinderung durch die flexible Rückhaltevorrichtung unterteilt werden kann. Es ist in gleicher Weise bevorzugt, dass die flexible Rückhaltevorrichtung den gesamten seitlichen Ausschnitt abdeckt, wobei die Elemente die Rückhaltevorrichtung aber abgebremst überwinden oder passieren können. Je nach Positionierung der seitlichen Rückhaltevorrichtung lässt sich somit die Durchlassrate des seitlichen Ausschnitts für die ungeordneten Elemente aus dem ersten Aufnahmevolumen in den zweiten Aufnahmebehälter einstellen.

Gemäß einer weiteren nicht beanspruchten Ausgestaltung der Zufuhrvorrichtung ist eine erste umlaufende Außenwand des ersten Aufnahmebehälters an der ersten Auslassöffnung annähernd umlaufend gleichmäßig zum Boden und/oder zur Innenwand des zweiten Aufnahmebehälters beabstandet, wodurch ein Übergabespalt für ungeordnete Elemente aus dem ersten Aufnahmebehälter in den zweiten Aufnahmebehälter festgelegt ist.

Im Unterschied zum oben beschriebenen seitlichen Ausschnitt zur Übergabe von ungeordneten Elementen aus dem ersten Aufnahmevolumen an den zweiten Aufnahmebehälter ist die Übergabezone als umlaufender Übergabespalt zwischen dem ersten Aufnahmebehälter und dem zweiten Aufnahmebehälter definiert. Entsprechend ist es bevorzugt, den unteren Rand des ersten Aufnahmebehälters soweit vom Boden oder von der Innenwand des zweiten Aufnahmebehälters zu beabstanden, dass zumindest eine Lage an ungeordneten Elementen diesen Übergabespalt in Richtung des zweiten Aufnahmebehälters passieren kann, oder der Abstand kleiner als die zweifache maximale Abmessung eines Elements ist. Es ist ebenfalls bevorzugt, den Übergabespalt größer zu wählen, um auf diese Weise die Zahl der übertragenen ungeordneten Elemente vom ersten Aufnahmebehälter an den zweiten Aufnahmebehälter einzustellen.

Gemäß einer weiteren nicht beanspruchten Ausführungsform der Zufuhrvorrichtung weist der Übergabespalt eine Breite auf, sodass nur eine Lage an ungeordneten Elementen aus dem ersten Aufnahmebehälter durch den Übergabespalt in den zweiten Aufnahmebehälter abführbar ist.

Gemäß einer weiteren bevorzugten Ausgestaltung der erfindungsgemäßen Zufuhrvorrichtung weist der erste Aufnahmebehälter eine im Wesentlichen zylindrische Form auf und der zweite Aufnahmebehälter ist durch einen Vibrationsförderer, vorzugsweise einen Vibrationswendelförderer, gebildet. Es ist ebenfalls bevorzugt, den ersten Aufnahmebehälter viereckig oder mehreckig aufzubauen, solange die ungeordneten Elemente im ersten Aufnahmevolumen in ihrer Verarbeitung bzw. Zufuhr zum zweiten Aufnahmebehälter nicht behindert werden.

Gemäß einer weiteren bevorzugten Ausgestaltung der erfindungsgemäßen Zufuhrvorrichtung ist der erste Aufnahmebehälter mittig oder koaxial zumzweiten Aufnahmebehälter, vorzugsweise dem Vibrationsförderer, angeordnet.

Es hat sich als vorteilhaft erwiesen, wenn ausgehend von der mittigen oder koaxialen Anordnung die ungeordneten Elemente aus dem ersten Aufnahmebehälter an den zweiten Aufnahmebehälter übergeben werden. Auf diese Weise werden Zufuhrwege der ungeordneten Elemente verkürzt und somit die Taktzeit für die Zufuhr einzelner Elemente zum finalen Verarbeitungsort verringert.

VorliegendeBeschreibung offenbart zudem einen Nachrüstsatz für einen Vibrationsförderer oder einen Vibrationswendelförderer, sodass Elemente in ungeordneter Form, insbesondere Verbindungselement als Schüttgut, einem zweiten Aufnahmevolumen gebildet durch den Vibrationsförderer zuführbar sind. Der Nachrüstsatz weist die folgenden Merkmale auf: einen ersten Aufnahmebehälter, der ein erstes Aufnahmevolumen für die ungeordneten Elemente definiert, welches über eine erste Zufuhröffnung in dem ersten Aufnahmebehälter befüllbar und über eine erste Auslassöffnung in dem ersten Aufnahmebehälter entleerbar ist, eine Rahmenkonstruktion, an der der erste Aufnahmebehälter befestigbar ist, sodass der erste Aufnahmebehälter mit dem ersten Aufnahmevolumen zumindest teilweise in dem zweiten Aufnahmevolumen des Vibrationsförderers anordenbar ist, sodass ein Boden und/oder eine Innenwand des zweiten Aufnahmebehälters derart beabstandet zur ersten Auslassöffnung positioniert ist, dass der Boden und/oder die Innenwand des ersten Aufnahmevolumens eine Übergabezone für ungeordnete Elemente vom ersten Aufnahmebehälter in den Vibrationsförderer aufweist, und wobei zumindest der Boden und/oder die Innenwand des Vibrationsförderers in Bezug auf den ersten Aufnahmebehälter derart bewegbar ist, dass die ungeordneten Elemente durch die Bewegung des Bodens und/oder der Innenwand aus dem ersten Aufnahmevolumen des ersten Aufnahmebehälters in das zweite Aufnahmevolumen des Vibrationsförderers abführbar sind.

Der Nachrüstsatz für einen Vibrationsförderer eröffnet die Möglichkeit, die oben beschriebenen konstruktiven Eigenschaften und Vorteile der Zufuhrvorrichtung mithilfe eines bekannten Vibrationsförderers oder Vibrationswendelförderers zu realisieren. Entsprechend wird der bekannte Vibrationsförderer als zweiter Aufnahmebehälter mit einem zusätzlichen ersten Aufnahmebehälter ausgestattet, der bewegungsentkoppelt vom Vibrationsförderer angeordnet ist. Der erste Aufnahmebehälter dient der Aufnahme einer Menge an Elementen in ungeordneter Form, um diese unterstützt durch die Bewegung des Vibrationsförderers dosiert aus dem ersten Aufnahmebehälter über die Übergabezone an den Vibrationsförderer abzuführen. Basierend auf der vorgeschlagenen Rahmenkonstruktion lässt sich in bekannten Vibrationsförderern der bewegungsentkoppelte erste Aufnahmebehälter für eine bestimmte Menge ungeordneter Verbindungselemente positionieren. Dies gewährleistet die Realisierung der in Bezug auf die erfindungsgemäße Zufuhrvorrichtung beschriebenen konstruktiven Besonderheiten und Vorteile durch die Kombination eines bekannten Vibrationsförderers mit dem Nachrüstsatz.

Entsprechend ist es bevorzugt, dass eine erste umlaufende Außenwand des ersten Aufnahmebehälters angrenzend an dessen Auslassöffnung mindestens einen seitlichen Ausschnitt aufweist, der die Übergabezone definiert.

Gemäß einer weiteren bevorzugten Ausgestaltung des Nachrüstsatzes deckt der seitliche Ausschnitt einen Winkelbereich von 90° bis 180° bezogen auf eine Mittellängsachse des ersten Aufnahmebehälters ab. Es ist ebenfalls bevorzugt, dass sich der Winkelbereich auf einen Ausschnitt von 50° oder 60° oder 70° oder 80° beschränkt. Zudem ist es bevorzugt, eine Mehrzahl an seitlichen Ausschnitten in der ersten Außenwand des ersten Aufnahmebehälters vorzusehen.

Gemäß weiterer bevorzugter Ausgestaltungen weist die erste umlaufende Außenwand des ersten Aufnahmebehälters eine im Wesentlichen zylindrische Form auf. Zudem ist der erste Aufnahmebehälter vorzugsweise koaxial zum zweiten Aufnahmebehälter des Vibrationsförderers anordenbar.

Gemäß einer weiteren bevorzugten Ausgestaltung des Nachrüstsatzes ist der seitliche Ausschnitt durch eine flexible Rückhaltevorrichtung, vorzugsweise eine flexible Bürstenanordnung oder ein elastischer Schlauch oder ein Vorhang, blockiert, wodurch die ungeordneten Elemente in der Übergabezone in einer verlangsamten Bewegung im Vergleich zu einer Elementbewegung ohne flexible Rückhaltevorrichtung vom ersten Aufnahmebehälter an den zweiten Aufnahmebehälter zugeführt werden. Gemäß einer weiteren bevorzugten Ausgestaltung des Nachrüstsatzes ist die flexible Rückhaltevorrichtung positionsverstellbar in Bezug auf den seitlichen Ausschnitt oder eine Mehrzahl von seitlichen Ausschnitten des ersten Aufnahmebehälters angeordnet, um eine Größe einer Abdeckung des jeweiligen seitlichen Ausschnitts durch die flexible Rückhaltevorrichtung zu verändern.

Im Hinblick auf die konstruktive und die funktionale Ausgestaltung der flexiblen Rückhaltevorrichtung oder Bürstenanordnung in Kombination mit dem seitlichen Ausschnitt der ersten Außenwand des ersten Aufnahmebehälters wird auf die bereits oben präsentierte Beschreibung verwiesen. Diese gilt in gleicher Weise für den beschriebenen erfindungsgemäßen Nachrüstsatz.

Gemäß einer weiteren bevorzugten Ausgestaltung des Nachrüstsatzes weist der erste Aufnahmebehälter eine zylindrische Form auf und wird gemäß einer weiteren bevorzugten Ausgestaltung mittig oder koaxial in dem Vibrationsförderer angeordnet. Vorzugsweise liegen in dieser Ausführungsform die Mittellängsachsen des ersten Aufnahmebehälters und des zweiten Aufnahmebehälters auf einer durchgehenden Linie. Es ist ebenfalls bevorzugt, dass eine Rotationsachse des im Wesentlichen zylindrisch ausgebildeten ersten Aufnahmebehälters koaxial zu einer Rotationsachse des zweiten Aufnahmebehälters in Form des Virbrationsförderers oder Vibrationswendelförderers angeordnet ist.

Vorliegende Erfindung umfasst zudem ein Herstellungsverfahren für eine Zufuhrvorrichtung, wie sie oben in unterschiedlichen bevorzugten Ausgestaltungen beschrieben worden ist. Das Herstellungsverfahren der Zufuhrvorrichtung weist die folgenden Schritte auf: Bereitstellen eines Vibrationsförderers, Bereitstellen einer Rahmenkonstruktion zumindest oberhalb des Vibrationsförderers und Befestigen eines ersten Aufnahmebehälters an der Rahmenkonstruktion, der durch eine erste umlaufende Außenwand ein erstes Aufnahmevolumen für die ungeordneten Elemente definiert, welches über eine erste Zufuhröffnung in dem ersten Aufnahmebehälter befüllbar und über eine erste Auslassöffnung in dem ersten Aufnahmebehälter entleerbar ist, sodass eine Übergabezone für ungeordnete Elemente von dem ersten Aufnahmebehälter in den zweiten Aufnahmebehälter vorhanden ist.

Vorliegende Erfindung offenbart zudem ein Zufuhrverfahren für eine Mehrzahl ungeordneter Elemente, insbesondere Verbindungselemente als Schüttgut, mithilfe einer der oben beschriebenen Ausgestaltungen der Zufuhrvorrichtung. Das Zufuhrverfahren weist die folgenden Schritte auf: Zuführen einer Mehrzahl von ungeordneten Elementen in das erste Aufnahmevolumen des ersten Aufnahmebehälters, Bewegen der zweiten Innenwand des zweiten Aufnahmebehälters in Bezug auf den ersten Aufnahmebehälter, vorzugsweise Schwingen der zweiten Innenwand, und Abführen von ungeordneten Elementen aus dem ersten Aufnahmebehälter über die Übergabezone in das zweite Aufnahmevolumen des zweiten Aufnahmebehälters.

Mithilfe der bereits oben beschriebenen konstruktiven Besonderheiten der erfindungsgemäßen und erfindungsgemäß bevorzugten Zufuhrvorrichtung ist eine gesteuerte Anzahl an ungeordneten Elementen des ersten Aufnahmevolumens aus diesem ersten Aufnahmevolumen in den zweiten Aufnahmebehälter, vorzugsweise einen Vibrationsförderer, abführbar. Dabei werden bevorzugt Schwingungen in Kombination mit dem Staudruck der ungeordneten Elemente im ersten Aufnahmebehälter genutzt, um eine gesteuerte Anzahl der ungeordneten Elemente durch die Übergabezone an den bevorzugten Vibrationsförderer abzugeben.

Zur Steuerung der Anzahl der aus dem ersten Aufnahmebehälter an den zweiten Aufnahmebehälter übergebenen Elemente ist es bevorzugt, eine Bürstenanordnung zu versetzen, die zumindest teilweise einen seitlichen Ausschnitt des ersten Aufnahmebehälters verschließt. Des Weiteren ist es bevorzugt, den ersten Aufnahmebehälter in Bezug auf die zweite Innenwand des zweiten Aufnahmebehälters zu versetzen, sodass ein Übergabespalt zwischen dem ersten und dem zweiten Aufnahmebehälter definiert wird.

### 4. Kurze Beschreibung der begleitenden Zeichnungen

Die vorliegende Erfindung wird unter Bezugnahme auf die begleitenden Zeichnungen näher erläutert. Es zeigen:
- Figur 1: eine bevorzugte Ausführungsform der erfindungsgemäßen Zufuhrvorrichtung mit einem Vibrationsförderer,
- Figur 2: eine vergrößerte Darstellung einzelner Komponenten der Ausführungsform der Zufuhrvorrichtung aus Figur 1,
- Figur 3: eine Explosionsdarstellung des ersten Aufnahmebehälters mit einer bevorzugten versetzbaren Bürstenanordnung,
- Figur 4: eine vergrößerte Darstellung einer bevorzugten Ausgestaltung der Übergabezone für Elemente zwischen dem ersten und dem zweiten Aufnahmebehälter,
- Figur 5: eine vergrößerte Darstellung einer weiteren nicht beanspruchten Ausgestaltung der Übergabezone für Elemente zwischen dem ersten und dem zweiten Aufnahmebehälter,
- Figur 6: eine bevorzugte Ausführungsform des ersten Aufnahmebehälters mit einer inneren schraubenförmigen Transportwand für Elemente,
- Figur 7: eine bevorzugte Ausführungsform des erfindungsgemäßen Nachrüstsatzes vorliegender Erfindung,

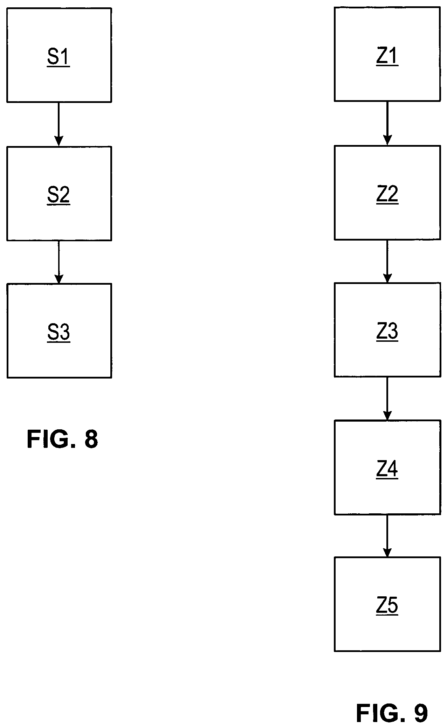

- Figur 8: ein Flussdiagramm eines bevorzugten Herstellungsverfahrens gemäß vorliegender Erfindung und
- Figur 9: ein Flussdiagramm eines bevorzugten Zufuhrverfahrens gemäß vorliegender Erfindung.

### 5. Detaillierte Beschreibung der bevorzugten Ausführungsformen

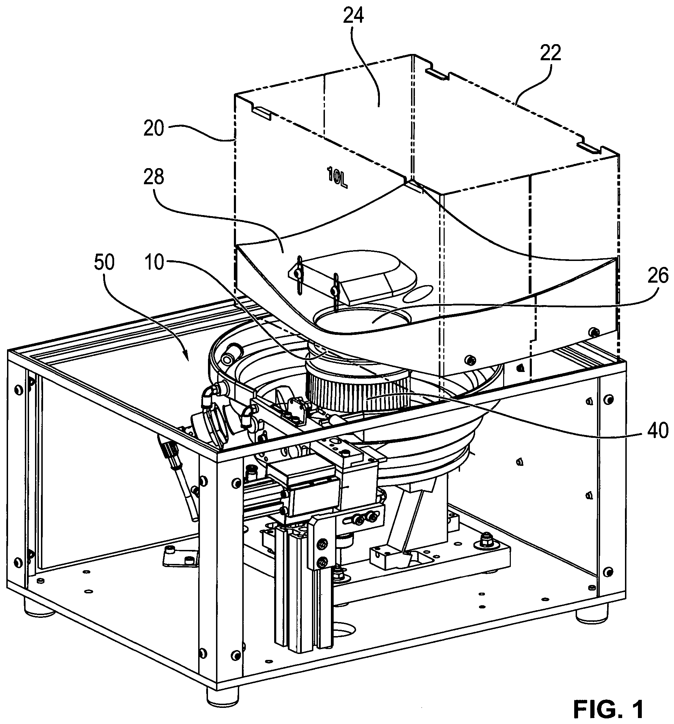

Eine bevorzugte Ausführungsform der erfindungsgemäßen Zufuhrvorrichtung 1 ist in Figur 1 dargestellt. Die Zufuhrvorrichtung 1 dient der Zufuhr von Elementen 3, die als ungeordnete Menge vorliegen. Derartige Elemente 3 sind vorzugsweise Verbindungselemente, wie Stanzniete, Blindnietmuttern, Einpressmuttern, Schweißhilfsfügeteile, Nägel, Gewindebolzen o. ä.

Um die Elemente 3 einem Verarbeitungsort zuzuführen, wie vorzugsweise einem Setzgerät für Blindnietmuttern oder Stanzniete oder Bolzen, wird zunächst eine Ausgangsmenge der Elemente 3 in ungeordneter Form, also als Schüttgut, bereitgestellt. Die Ausgangsmenge der Elemente 3 stellt sicher, dass eine ausreichende Anzahl an Elementen 3 für beispielsweise einen Produktionszyklus und die darin zu erzeugende Anzahl an Verbindungen oder Fügestellen vorhanden ist.

Die Zufuhrvorrichtung 1 umfasst einen ersten Aufnahmebehälter 10, in dem eine ungeordnete Menge an Elementen 3, vorzugsweise als Schüttgut, aufgenommen ist. Der Aufnahmebehälter 10 gemäß Figur 1 besteht aus einem zylindrischen Hohlkörper mit einer umlaufenden mantelähnlichen ersten Außenwand 12. Die umlaufende Außenwand 12 schließt ein erstes Aufnahmevolumen 14 ein, welches im Anwendungsfall durch eine Menge ungeordneter Elemente 3 (nicht gezeigt), vorzugsweise Blindnietmuttern, teilweise oder vollständig gefüllt ist.

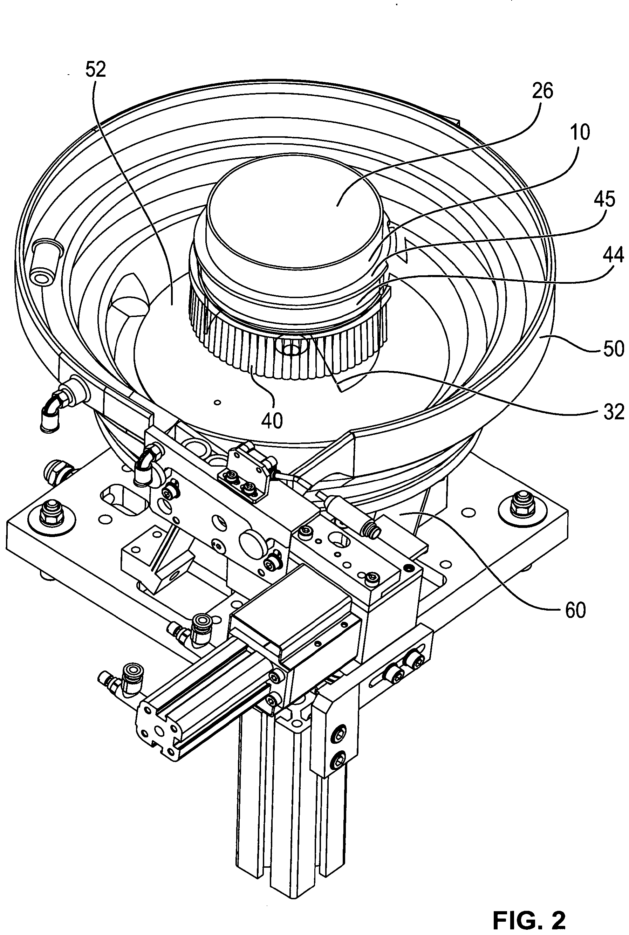

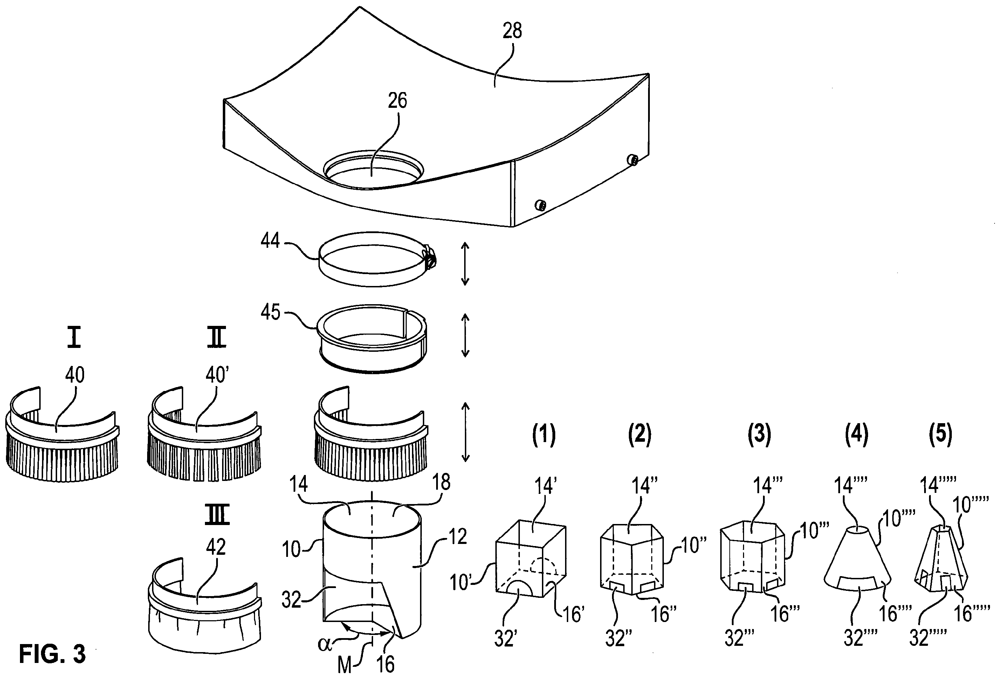

Während in den Figuren 1 bis 5 ein zylindrischer Aufnahmebehälter 10 gezeigt ist, sind auch alternative Formen des ersten Aufnahmebehälters 10 bevorzugt. Voraussetzung der alternativen Formen ist die Bereitstellung des ersten Aufnahmevolumens 14 im Inneren des ersten Aufnahmebehälters 10. Daher ist es ebenfalls bevorzugt, den ersten Aufnahmebehälter 10 quaderförmig mit einer quadratischen oder einer rechteckigen Grundfläche (siehe 10') oder als Prisma mit einer fünfeckigen (siehe 10") oder einer sechseckigen Grundfläche (siehe 10‴) vorzusehen. Weitere alternative Formen des ersten Aufnahmebehälters 10 stellen ein Pyramidenstumpf 10‴ʺ oder ein Kegelstumpf 10ʺʺ dar (siehe Figur 3).

Zur weiteren Erläuterung der bevorzugten konstruktiven Merkmale des ersten Aufnahmebehälters 10 bis 10‴ʺ wird auf den zylindrisch geformten ersten Aufnahmebehälter 10 der Figuren Ziffer 1 bis 5 Bezug genommen. Die an diesem Beispiel realisierten konstruktiven und funktionellen Merkmale gelten analog auch für die anders geformten ersten Aufnahmebehälter 10' bis 10‴ʺ.

Der zylindrisch geformte erste Aufnahmebehälter 10 ist über eine Rahmenkonstruktion 20 - siehe die Strich-Punkt-Linien in Figur 1 - fest im Raum angeordnet. Über die bevorzugte Rahmenkonstruktion 20 ist gewährleistet, dass die im Aufnahmevolumen 14 befindliche Mehrzahl an Elementen 3, vorzugsweise nur durch die Schwerkraft, also gravitationsgetrieben, in Richtung einer Auslassöffnung 16 des ersten Aufnahmebehälters 10 bewegt wird.

Die Auslassöffnung 16 des ersten Aufnahmebehälters 10 ist gegenüber einem zweiten Aufnahmebehälter 50, vorzugsweise gegenüber einem Boden 52 und/oder einer Innenwand 51 des zweiten Aufnahmebehälters 50, angeordnet. Sofern der erste Aufnahmebehälter 10 eine zylindrische Form besitzt, wird die Auslassöffnung 16 durch eine offene und dem zweiten Aufnahmebehälter 50 zugewandte Stirnseite gebildet. Das gleiche gilt bevorzugt für die alternativen Formen des ersten Aufnahmebehälters 10; 10'; 10"; 10‴; 10ʺʺ und 10‴ʺ, wie sie in Figur 3 dargestellt sind. Entsprechend haben die alternativen ersten Aufnahmebehälter 10 bis 10‴ʺ eine annähernd runde Auslassöffnung 16, eine viereckige Auslassöffnung 16', eine fünfeckige Auslassöffnung 16", eine sechseckige Auslassöffnung 16‴, eine runde Auslassöffnung 16ʺʺ und eine fünfeckige Auslassöffnung 16‴ʺ.

Gegenüber der Auslassöffnung 16 bis 16‴ʺ ist jeweils eine Einlassöffnung 18 bis 18‴ʺ vorgesehen. Diese weist eine der Gestalt des ersten Aufnahmebehälters 10 entsprechende Form auf, wie es beispielgebend in Figur 3 erkennbar ist.

Gemäß einer bevorzugten Ausgestaltung vorliegender Erfindung stellt der erste Aufnahmebehälter 10 bis 10‴ʺ ein ausreichend großes erstes Aufnahmevolumen 14 bis 14‴ʺ bereit, um eine Mehrzahl von Elementen 3 aufzunehmen. Um das Aufnahmevolumen 14 bis 14‴ʺ zu vergrößern, so dass eine flexible Anpassung an beispielsweise Produktionserfordernisse möglich ist, ist ein Bunker 22 vorgesehen.

Der Bunker 22 stellt ein beliebig geformtes - hier quaderförmig - Speichervolumen 24 bereit. In dem Speichervolumen 24 sind weitere Elemente 3 aufnehmbar, die über einen Bunkerauslass 26 an den ersten Aufnahmebehälter 10 überführbar sind.

Der Bunkerauslass 26, der vorzugsweise manuell oder automatisch verschließbar ist, ist in einem Bunkerboden 28 vorgesehen. Vorzugsweise ist der Bunkerboden 28 geneigt oder abschüssig in Richtung des Bunkerauslasses 26 geformt. Dadurch wird die schwerkraftgetriebene Bewegung der Elemente 3 zum Bunkerauslass 26 unterstützt. In diesem Zusammenhang ist es ebenfalls bevorzugt, einen Antrieb der Elemente 3 in Richtung Bunkerauslass 26 innerhalb des Bunkers 22 vorzusehen.

Der Bunker 22 ist an der Rahmenkonstruktion 20 befestigt und damit vom zweiten Aufnahmebehälter 50 bewegungsentkoppelt. Gemäß einer bevorzugten Ausgestaltung der Zufuhrvorrichtung 1 ist der erste Aufnahmebehälter 10 über den Bunker 22 fest an der Rahmenkonstruktion 20 angeordnet. Gemäß obiger Alternative ist der erste Aufnahmebehälter 10 direkt an der Rahmenkonstruktion 22 befestigt und damit von einer Bewegung des zweiten Aufnahmebehälters 50 entkoppelt.

In Richtung der Schwerkraft der Elemente 3 im ersten Aufnahmebehälter 10 ist ein zweiter Aufnahmebehälter 50 angeordnet. Dieser definiert über eine umlaufende Wand 54 und einen Boden52 ein zweites Aufnahmevolumen 56. Vorzugsweise ist der zweite Aufnahmebehälter 50 schalenförmig ausgebildet, sodass der erste Aufnahmebehälter 10 mit seinem ersten Aufnahmevolumen 14 zumindest teilweise in dem zweiten Aufnahmevolumen 56 angeordnet ist. Dazu wird das zweite Aufnahmevolumen 56 vorzugsweise durch den Boden 52, die umlaufende Wand 54 und deren oberen Rand 53 definiert.

Gemäß einer bevorzugten Ausgestaltung vorliegender Erfindung ist der zweite Aufnahmebehälter 50 ein bekannter Vibrationsförderer, Vibrationswendelförderer oder Schwingförderer. Ein Schwingförderer ist eine mechanische Fördereinrichtung für Schüttgut, bei der bevorzugt das zu transportierenden Medium mittels linearer Schwingungen bewegt wird. Derartige Anordnungen sind beispielsweise in DE 100 26 765 A1 und DE 100 29 836 C2 beschrieben.

Die Auslassöffnung 16 bis 16‴ʺ des ersten Aufnahmebehälters 10 bis 10‴ʺ ist innerhalb des zweiten Aufnahmevolumens 56 beabstandet und benachbart zum Boden 52 angeordnet. Aufgrund dieser Anordnung ergibt sich eine Übergabezone der Elemente 3, die aus dem ersten Aufnahmevolumen 14 bis 14‴ʺ des ersten Aufnahmebehälters 10 bis 10‴ʺ in das zweite Aufnahmevolumen 56 des zweiten Aufnahmebehälters 50 übertragen werden. Zu diesem Zweck ist der erste Aufnahmebehälter 10 bis 10‴ʺ in der Rahmenkonstruktion 20 fest angeordnet, dass unterschiedliche bevorzugte Konfigurationen der Übergabezone 30; 30" vorliegen. Die Konfiguration der Übergabezone 30; 30' soll gewährleisten, dass bevorzugt unterstützt durch Schwingungen des Vibrationsförderers in Form des zweiten Aufnahmebehälters 50 die Elemente 3 aus dem ersten Aufnahmebehälter 10 in einer bestimmten Rate, also Anzahl pro Zeiteinheit, in den Vibrationsförderer 50 abgeführt werden. Diese Rate stellt sicher, dass eine angeschlossene Verarbeitungsvorrichtung, beispielsweise ein Setzgerät für Blindnietmuttern, verlässlich versorgt wird.

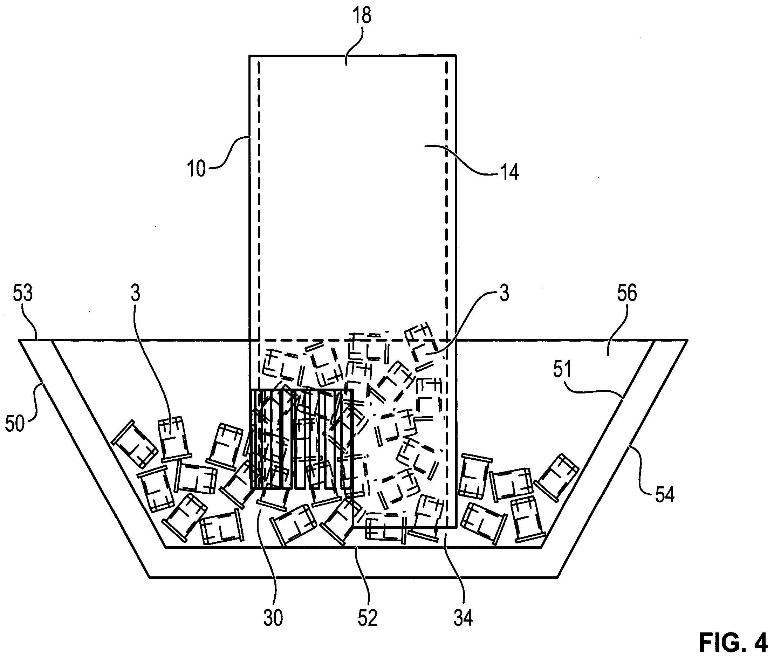

Erfindungsgemäß (siehe Figur 4) wird die Auslassöffnung 16 durch einen seitlichen Ausschnitt 32 ergänzt. Der seitliche Ausschnitt 32 ist in seiner Größe wählbar, um nur einer bestimmten Anzahl an Elementen 3 den Übergang aus dem ersten Aufnahmevolumen 14 in den Vibrationsförderer 50 zu gestatten. Daher erstreckt sich vorzugsweise der seitliche Ausschnitt 32 über einen Winkelbereich von 90 °≤α≤180 ° bezogen auf eine Mittellängsachse M des ersten Aufnahmebehälters 10.

In gleicher Weise ist es bevorzugt, angrenzend an die Auslassöffnung 16 eine Mehrzahl verteilt angeordneter seitlicher Ausschnitte 32 vorzusehen.

Anhand der bevorzugten unterschiedlichen Ausgestaltungen des ersten Aufnahmebehälters 10 bis 10‴ʺ in Figur 3 ist illustriert, wie weitere seitliche Ausschnitte 32' angeordnet, geformt und auf den ersten Aufnahmebehälter 10 verteilt angeordnet sein können. So sind vorzugsweise an einer oder mehreren Seitenflächen des ersten Aufnahmebehälters 10 bis 10‴ʺ ein oder mehrere seitliche Ausschnitte 32' positioniert.

Vorzugsweise ist diese Anordnung der seitlichen Ausschnitte 32' derart gewählt, dass die Elemente 3 in bestimmten Bereichen an den zweiten Aufnahmebehälter 50 abgegeben werden. Die Größe der seitlichen Ausschnitte 32 reguliert vorzugsweise die Rate und Richtung der die Übergabezone 30 passierenden Elemente 3.

Erfindungsgemäß wird der mindestens eine seitliche Auslass 32 durch eine flexible Rückhaltevorrichtung, insbesondere eine Bürstenanordnung 40, ein flexibles Schlauchende oder ein flexibler Vorhang, zumindest teilweise blockiert. Im Folgenden werden die Eigenschaften der flexiblen Rückhaltevorrichtung anhand der flexiblen Bürstenanordnung 40 erläutert. Die Bürstenanordnung 40 besteht aus einer Mehrzahl parallel oder geneigt zueinander verlaufender Borsten, die ähnlich einem Vorhang den seitlichen Ausschnitt 32; 32' zumindest teilweise verschließen. Dazu sind die Borsten flexibel vorgesehen, sodass die Elemente 3, die die Übergabezone 30 passieren, die Borsten zum Passieren beiseite drücken können. Die Bürstenanordnung 40 besteht dazu bevorzugt aus einem flexiblen Kunststoff, Gummi oder einem ähnlichen Material.

In den Ausführungsformen 40 und 40' der Bürstenanordnungen in Figur 3 weisen die Borsten eine unterschiedliche Dicke und damit verbundene Flexibilität auf. Die bevorzugte Ausführungsform am Bezugszeichen 42 zeigt eine Anordnung, die anstelle der Borsten einen flexiblen Vorhang oder eine ähnliche Konstruktion umfasst. Auch dieser Vorhang hält ähnlich wie die Borsten die Elemente 3 bis zu einem bestimmten Grad zurück, bis die Elemente 3 für ein Passieren der Übergangszone 30 die Borsten oder den Vorhang beiseite drücken können.

Vorzugsweise wird die Bürstenanordnung 40; 40' oder der Vorhang 42 mithilfe einer Schelle 44 und eines Rings 45 am ersten Aufnahmebehälter 10 bis 10‴ʺ befestigt. Es versteht sich, dass der Ring 45 und die Schelle 44 in ihrer Form an die jeweilige Außenkontur des ersten Aufnahmebehälters 10 bis 10‴ʺ angepasst oder anpassbar sind.

Mithilfe zumindest der Schelle 44 ist vorzugsweise gewährleistet, dass die Bürstenanordnung 40; 40'; 42 parallel zur Längsachse M des ersten Aufnahmebehälters 10 bis 10‴ʺ an unterschiedlichen axialen Positionen befestigt werden kann. Entsprechend ist durch gezielte axiale Positionierung der Bürstenanordnung 40; 40'; 42 auch die Größe einer Abdeckung des seitlichen Ausschnitts 32 oder der seitlichen Ausschnitte durch die Bürstenanordnung einstellbar. Die axiale Verstellbarkeit der Schelle 44 und zumindest der Bürstenanordnung 40; 40'; 42 ist durch die Pfeile in Figur 3 angezeigt.

Weiterhin bevorzugt ist der erste Aufnahmebehälter 10 mit seinem unteren Rand bzw. seiner Auslassöffnung 16 derart von der Innenwand 52 des zweiten Aufnahmebehälters 50 beabstandet, dass die Übergabezone 30 nur durch den mindestens einen seitlichen Auslass 32 bis 32‴ʺ gebildet wird. Entsprechend ist es bevorzugt, dass ein Spalt 34 zwischen dem ersten Aufnahmebehälter 10 bis 10‴ʺ und der Innenwand 52 so klein vorgegeben ist, dass kein Element 3 diesen Spalt 34 passieren kann (siehe Figur 4).

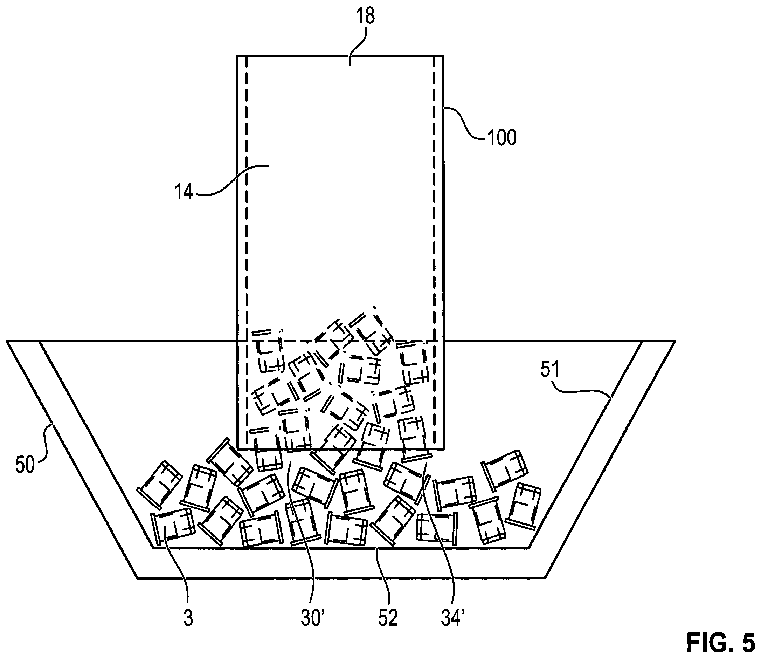

Gemäß einem nicht beanspruchten Beispiel weist der erste Aufnahmebehälter 100 (siehe Figur 5) gerade keinen seitlichen Ausschnitt 32 auf. Vielmehr ist der erste Aufnahmebehälter 100 soweit parallel in Richtung seiner Längsachse vom Boden 52 beabstandet, dass mindestens eine Lage von Elementen 3 auf der Innenwand 52 den Spalt 34' passieren kann (siehe Figur 5). Somit wird vorzugsweise die Übergabezone 30' durch den Spalt 34' gebildet.

In den oben beschriebenen bevorzugten Ausführungsformen vorliegender Erfindung ist das erste Aufnahmevolumen 14 bis 14‴ʺ durch den Boden 52 und die Innenwand 51 des zweiten Aufnahmebehälters 50 begrenzt. Entsprechend begrenzt bevorzugt der Boden 52 eines Vibrationsförderers das erste Aufnahmevolumen 14 bis 14‴ʺ. Somit können die Elemente 3 allein aufgrund ihrer Schwerkraft und des daraus resultierenden Staudrucks nicht die Übergangszone 30; 30' passieren. Die für das Passieren der Übergangszone 30; 30' nötige Energie wird vorzugsweise den Elementen 3 im ersten Aufnahmevolumen 14 bis 14‴ʺ durch die Schwingungen, vorzugsweise lineare Schwingungen, der Innenwand 52 des Vibrationsförderers zugeführt. Der zweite Aufnahmebehälter 50 wird vorzugsweise durch den Vibrationsförderer (siehe oben) gebildet. Dieser bewegt sich im Vergleich zu den im ersten Aufnahmevolumen 14 bis 14‴ʺ zunächst ruhenden Elementen 3 schwingend, insbesondere der Boden 52 schwingt, wodurch dann die Elemente 3 aus dem ersten Aufnahmevolumen 14 bis 14‴ʺ durch die Übergangszone 30; 30' in das zweite Aufnahmevolumen 56 im Vibrationsförderer 50 überführt werden.

Somit begrenzt der Boden 52 des zweiten Aufnahmebehälters 50 zunächst das erste Aufnahmevolumen 14 bis 14‴ʺ mit den gespeicherten Elementen 3 entgegen der Schwerkraft der Elemente 3. Sobald der das erste Aufnahmevolumen 14 bis 14‴ʺ begrenzende Boden 52 vorzugsweise in Kombination mit der angrenzenden Innenwand 51 in Schwingungen versetzt wird, übertragen sich diese Schwingungen auf die Elemente 3 und lösen aus und unterstützen deren Überführung aus dem ersten Aufnahmevolumen 14 bis 14‴ʺ in das zweite Aufnahmevolumen 56. Dabei schwingt der zweite Aufnahmebehälter 50 bevorzugt quer oder umlaufend zu seiner Mittellängsachse.

In diesem Zusammenhang sind aber auch Schwingungen in anderen Schwingungsebenen und Schwingungsrichtungen bevorzugt, solange sie eine Bewegung der Elemente 3 aus dem ersten Aufnahmevolumen 14 bis 14‴ʺ in das zweite Aufnahmevolumen 56 auslösen und unterstützen.

Entsprechend ist es bevorzugt, anstelle des Vibrationsförderers den zweiten Aufnahmebehälter 50 durch einen schalenförmigen Behälter mit einer angetriebenen Schwungmasse bereitzustellen. Die Schwungmasse besteht bevorzugt aus einer rotierenden Masse, die asymmetrisch zur Rotationsachse der rotierenden Masse angeordnet ist.

Gemäß den bevorzugten Ausführungsformen der Figuren 3 bis 4 und dem Beispiel der Figur 5 stellt der erste Aufnahmebehälter 10 bis 10‴ʺ das durchgängige erste Aufnahmevolumen 14 bis 14‴ʺ bereit. Entsprechend erzeugen die Elemente 3 abhängig von der Füllhöhe des ersten Aufnahmevolumens 14 bis 14‴ʺ einen Staudruck an dem begrenzenden Boden 52 des zweiten Aufnahmebehälters 50, der durch die Schwerkraft der Elemente 3 im ersten Aufnahmevolumen 14 bis 14‴ʺ bestimmt ist.

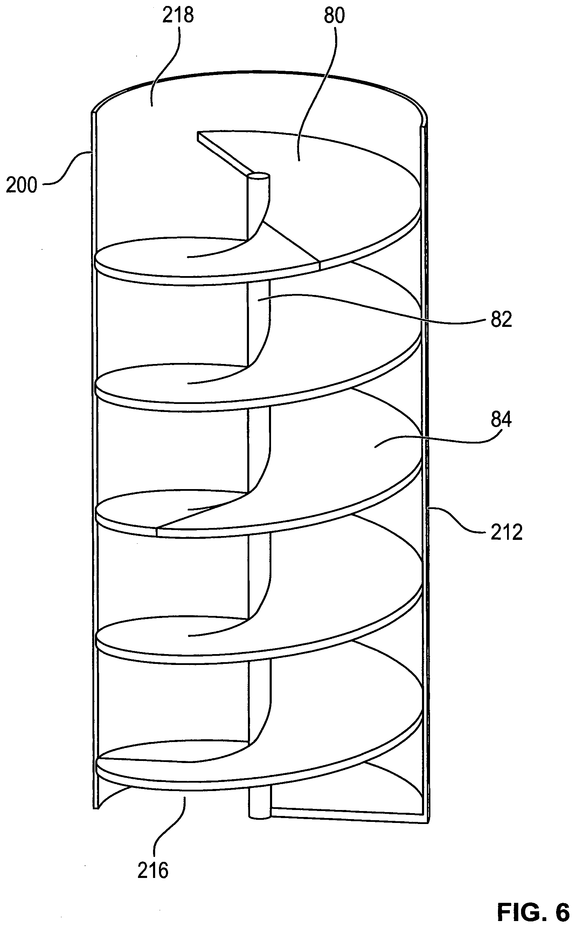

Um den durch die Elemente 3 auf den Boden 52 und/oder die Innenwand 51 ausgeübten Staudruck zu steuern, ist gemäß der in Figur 6 dargestellten bevorzugten Ausgestaltung vorliegender Erfindung eine Schraubenspirale 80 innerhalb des ersten Aufnahmebehälters 200 angeordnet. Der erste Aufnahmebehälter 200 hat vorzugsweise eine hohlzylindrische Form mit einer Außenwand 212, einer ersten Zufuhröffnung 218 und einer ersten Auslassöffnung 216.

Die Schraubespirale 80 umfasst eine spiralförmig um die Mittellängsachse 82 des ersten Aufnahmebehälters 200 umlaufende Radialwand 84. Die Radialwand 84 beginnt an der Zufuhröffnung 218 und endet an der Auslassöffnung 216. Sobald die Elemente 3 (nicht gezeigt) als Schüttgut dem ersten Aufnahmebehälter 200 direkt oder über den vorgeschalteten Bunker 22 zugeführt werden, bewegen sich die Elemente 3 auf der Radialwand 84 in Richtung Auslassöffnung 216.

Gemäß einem nicht beanspruchten Beispiel ist der erste Aufnahmebehälter 200 gemäß Figur 5 oberhalb der Innenwand 52 des zweiten Aufnahmebehälters 50 angeordnet. Dadurch wird die Übergabezone durch den Übergabespalt 30' zwischen dem Rand 217 benachbart zur Auslassöffnung 216 und der Innenwand 52 gebildet. Der Übergabespalt 30' ist bevorzugt groß genug, dass mindestens eine Lage an Elementen 3 auf dem Boden 52 den Übergabespalt 30' und damit die Übergabezone vom ersten in das zweite Aufnahmevolumen 50 passieren kann.

Erfindungsgemäß ist angrenzend an die erste Auslassöffnung 216 ein seitlicher Ausschnitt mit einer Bürstenanordnung (nicht gezeigt) vorgesehen, um den Austritt von Elementen 3 aus dem ersten Aufnahmebehälter 200 zu steuern.

Auch für die bevorzugte Ausgestaltung des ersten Aufnahmebehälters 200 gemäß Figur 6 gilt, dass dieser bewegungsentkoppelt vom zweiten Aufnahmebehälter 50 in der Zufuhrvorrichtung 1 angeordnet ist.

Vorzugsweise hält die Rahmenkonstruktion 20 gemäß Figur 1 den ersten Aufnahmebehälter 200. Dazu stützt sich die Rahmenkonstruktion unabhängig vom zweiten Aufnahmebehälter 50 am Boden stabil ab oder ist geeignet aufgehangen. Zudem ist es bevorzugt, auch den ersten Aufnahmebehälter 200 mit einem Bunker 22 zu kombinieren, um ein zusätzliches Volumen 24 an Elementen 3 bereitstellen zu können.

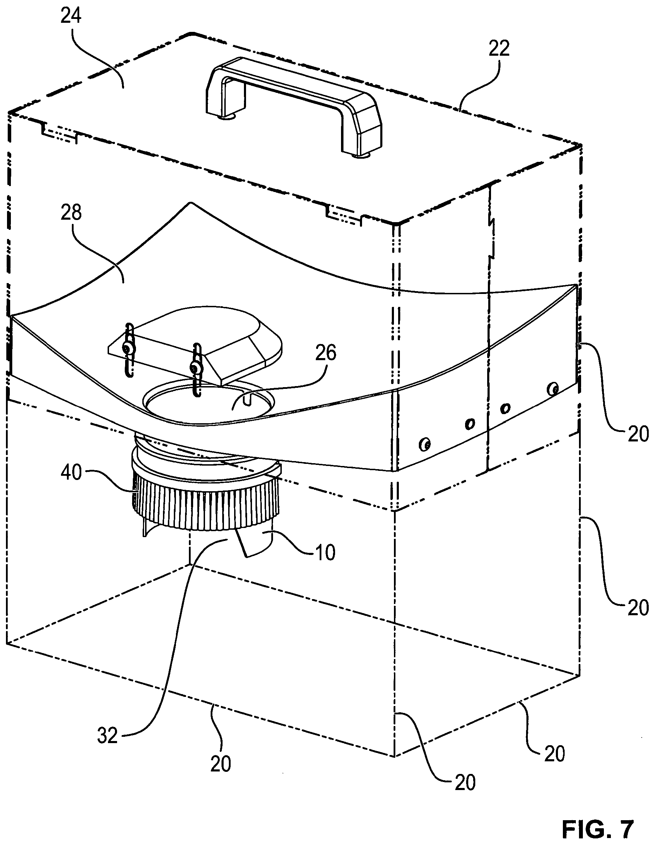

Vorliegende Beschreibung beschreibt zudem einen Nachrüstsatz für einen bekannten Vibrations- oder Schwingförderer, wie er beispielgebend in Figur 7 gezeigt ist.

Während der Schwingförderer das zweite Aufnahmevolumen 50 bildet, wird über dem Schwingförderer mit Hilfe einer Rahmenkonstruktion 20 der erste Aufnahmebehälter 10 bis 10‴ʺ, 200 bewegungsentkoppelt vom Schwingförderer angeordnet. Dazu stützt sich die Rahmenkonstruktion 20 unabhängig vom Schwingförderer auf einem festen Untergrund ab oder ist entsprechend aufgehangen, sodass sich die Bewegung des Schwingförderers nicht auf den ersten Aufnahmebehälter überträgt. Zudem ist es bevorzugt, den ersten Aufnahmebehälter 10 bis 10‴ʺ, 200 gemeinsam mit dem Bunker 22 in der Rahmenkonstruktion 20 zu befestigen.

Der Nachrüstsatz realisiert mit einem bekannten Vibrationsförderer die gleichen konstruktiven und funktionellen Eigenschaften, wie sie oben in Bezug auf die verschiedenen bevorzugten Ausführungsformen vorliegender Erfindung beschrieben worden sind.

Vorliegende Erfindung offenbart zudem ein Herstellungsverfahren für die oben beschriebene Zufuhrvorrichtung 1. Im Rahmen des Herstellungsverfahrens wird in einem ersten Schritt S1 ein bekannter Vibrationsförderer oder Schwingförderer bereitgestellt. Diese bekannte Vorrichtung zeichnet sich durch einen schalenförmigen Aufnahmebehälter 50 aus. Mithilfe eines motorischen Antriebs ist der Aufnahmebehälter 50 in Schwingungen versetzbar. Diese Schwingungen des Aufnahmebehälters 50 haben zur Folge, dass im Aufnahmebehälter 50 vorhandene Elemente 3 radialauswärts bewegt werden, um sie vorzugsweise einzeln und/oder in einer bestimmten Orientierung aus dem zweiten Aufnahmebehälter 50 abzuführen.

In einem zweiten Herstellungsschritt S2 wird eine Rahmenkonstruktion 20 bereitgestellt. Die Rahmenkonstruktion 20 ist angepasst, um oberhalb des Aufnahmebehälters 50 des Schwingförderers und zumindest teilweise innerhalb des zweiten Aufnahmevolumens 56 des Schwingförderers den ersten Aufnahmebehälter 10 bis 10‴ʺ, 200 in einem dritten Herstellungsschritt S3 anzuordnen und zu befestigen. In diesem Zusammenhang wird der erste Aufnahmebehälter 10 bis 10‴ʺ, 200 derart befestigt, dass er gemäß obiger Beschreibung der bevorzugten Ausführungsformen der Zufuhrvorrichtung 1 benachbart zur Innenwand 52 sowie bewegungsentkoppelt vom Schwingförderer, also in Ruhe, in der Rahmenkonstruktion 20 fest angeordnet ist.

Für dieses Herstellungsverfahren wird vorzugsweise ein neuer Vibrationsförderer mit dem ersten Aufnahmebehälter 10 bis 10‴ʺ; 200 kombiniert oder ein bestehender Vibrationsförderer mit dem Nachrüstsatz weiter ausgestattet.

Um eine ausreichende Anzahl an Elementen 3 bereitstellen zu können, wird der erste Aufnahmebehälter 10 bis 10‴ʺ; 200 vorzugsweise mit einem Bunker 22 kombiniert (siehe oben). Der Bunker 22 wird ebenfalls bevorzugt in der Rahmenkonstruktion 20 befestigt.

Vorliegende Erfindung umfasst zudem ein Zufuhrverfahren für eine Mehrzahl von Elementen 3 mit der oben beschriebenen Zufuhrvorrichtung 1. In einem ersten Schritt Z1 wird die Mehrzahl von ungeordneten Elementen 3 dem ersten Aufnahmevolumen 14 bis 14‴ʺ; 214 im ersten Aufnahmebehälter 10 bis 10‴ʺ; 200 zugeführt. Nach der Zufuhr der Elemente 3 zum ersten Aufnahmebehälter 10 bis 10‴ʺ; 200 stehen die Elemente 3 an der Innenwand 52 des zweiten Aufnahmebehälters 50 an bzw. werden an dieser gestaut. Denn allein durch die Schwerkraft der Elemente 3 innerhalb des ersten Aufnahmevolumens 14 bis 14‴ʺ sind die Elemente 3 nicht in der Lage, die Übergabezone 30; 30' in das zweite Aufnahmevolumen 56 zu passieren.

Um den im ersten Aufnahmebehälter 10 bis 10‴ʺ; 200 gespeicherten und gestauten Elementen 3 die nötige Bewegungsenergie für das Passieren der Übergabezone 30; 30' zuzuführen, wird die Innenwand 52 des zweiten Aufnahmebehälters 50 in Bezug auf den ersten Aufnahmebehälter 10 bis 10‴ʺ; 200 bewegt. Diese Bewegung wird vorzugsweise durch Schwingungen des Schwingförderers bereitgestellt.

Mithilfe der durch den Schwingförderer auf die Elemente 3 im ersten Aufnahmebehälter 10 bis 10‴ʺ; 200 übertragenen Bewegungsenergie in Form von Schwingungen werden die Elemente 3 in die Lage versetzt, die Übergabezone 30; 30' zu passieren. Entsprechend werden im Schritt Z5 die ungeordneten Elemente 3 aus dem ersten Aufnahmebehälter 10 bis 10‴ʺ; 200 in das zweite Aufnahmevolumen 56 des zweiten Aufnahmebehälters 50 abgeführt.

Um die Rate an Elementen 3, die durch die Übergabezone aus dem ersten Aufnahmevolumen 14 bis 14‴ʺ; 214 in das zweite Aufnahmevolumen 56 abgeführt werden, entsprechend einzustellen, wird in einem weiteren Zufuhrschritt Z3 vorzugsweise die Bürstenanordnung 40 in ihrer axialen Position bezogen auf die Längsachse des ersten Aufnahmebehälters 10 bis 10‴ʺ; 200 versetzt. Auf diese Weise ist es möglich, mithilfe der axialen Position der Bürstenanordnung 40 in Kombination mit dem seitlichen Ausschnitt 32 bis 32‴ʺ die Übergabezone 30 in ihrer Größe derart zu verändern, dass eine veränderliche Rate an Elementen 3 die Übergabezone 30; 30' passiert. Denn durch das Versetzen der Bürstenanordnung 40 in seiner axialen Position bezogen auf die Längsachse des ersten Aufnahmebehälters 10 bis 10‴ʺ; 200 wird die Abdeckung des seitlichen Ausschnitts 32 bis 32‴ʺ durch die Bürstenanordnung 40 verändert und auf diese Weise die Wirkung der Borsten auf die durchtretenden Elemente 3 und/oder die Abdeckung des seitlichen Ausschnitts 32 bis 32‴ʺ durch die Bürstenanordnung 40 verändert. Entsprechend können pro Zeiteinheit mehr oder weniger Elemente 3 die Übergabezone 30; 30' passieren.

Es ist ebenfalls bevorzugt, den ersten Aufnahmebehälter 100 in Bezug auf die zweite Innenwand 52 derart zu versetzen (Schritt Z4), dass der Übergabespalt 30' zwischen dem ersten und dem zweiten Aufnahmebehälter in seiner Breite verändert wird. Auf diese Weise ist ebenfalls die Anzahl der Elemente 3 einstellbar, die pro Zeiteinheit die Übergabezone 30' passieren können.

### 6. Bezugszeichenliste

- 1: Zufuhrvorrichtung
- 3: Elemente, insbesondere Verbindungselemente
- 10-10‴ʺ, 100, 200: erster Aufnahmebehälter
- 92, 200: erste Außenwand
- 14-14‴ʺ: erstes Aufnahmevolumen
- 16; 216: Auslassöffnung
- 18; 218: erste Zufuhröffnung
- 20: Rahmenkonstruktion
- 22: Bunker
- 24: Speichervolumen des Bunkers 22
- 26: Bunkerauslass
- 28: Bunkerboden
- 30; 30': Übergabezone
- 32: seitlicher Ausschnitt
- 34: Spalt
- 40: Bürstenanordnung
- 42: Vorhang
- 50: zweiter Aufnahmebehälter
- 51: Innenwand des zweiten Aufnahmebehälters 50
- 52: Boden des zweiten Aufnahmebehälters, insbesondere der Vibrationsförderer
- 53: oberer Rand der Innenwand 51
- 54: umlaufende Außenwand
- 56: zweites Aufnahmevolumen
- 80: Schraubenspirale
- 82: Mittellängsachse
- 84: Radialwand

## Patentansprüche

1. Eine Zufuhrvorrichtung (1), mit der Elemente (3) in ungeordneter Form einem zweiten Aufnahmevolumen (54) zuführbar sind, wobei die Elemente (3) in ungeordneter Form Verbindungselemente als Schüttgut sind und die Zufuhrvorrichtung (1) die folgenden Merkmale aufweist:
einen ersten Aufnahmebehälter (10, 10'; 10"; 10‴; 10""; 10‴ʺ; 100; 200), der eine erste umlaufende Außenwand (12; 212) aufweist und ein erstes Aufnahmevolumen (14, 14'; 14"; 14‴; 14ʺʺ; 14‴ʺ) für die ungeordneten Elemente (3) definiert, welches über eine erste Zufuhröffnung (18) befüllbar und über eine erste Auslassöffnung (16) entleerbar ist,
einen zweiten Aufnahmebehälter (50), der eine Innenwand (51) aufweist und das zweite Aufnahmevolumen (56) definiert, wobei
der erste Aufnahmebehälter (10, 10'; 10"; 10‴; 10ʺʺ; 10‴ʺ; 100; 200) mit dem ersten Aufnahmevolumen (14, 14'; 14"; 14‴: 14ʺʺ; 14‴ʺ) zumindest teilweise innerhalb des zweiten Aufnahmevolumens (54) angeordnet ist,
ein Boden (52) des zweiten Aufnahmebehälters (50) beabstandet zur ersten Auslassöffnung (16) so positioniert ist, dass das erste Aufnahmevolumen (14, 14'; 14"; 14‴; 14‴ʺ 14‴ʺ) durch die erste umlaufende Außenwand (12; 212) des ersten Aufnahmebehälters (10, 10'; 10"; 10‴, 10ʺʺ; 10‴ʺ; 100; 200) und die Innenwand (51) des zweiten Aufnahmebehälters (50) definiert und begrenzt ist und eine Übergabezone (30, 30') für ungeordnete Elemente (3) vom ersten Aufnahmebehälter (10, 10'; 10"; 10‴; 10ʺʺ; 10‴ʺ; 100; 200) in den zweiten Aufnahmebehälter (50) vorhanden ist, und wobei
zumindest der Boden (52) des zweiten Aufnahmebehälters (50) in Bezug auf den ersten Aufnahmebehälter (10, 10'; 10"; 10‴; 10ʺʺ; 10‴ʺ; 100; 200) derart bewegbar ist, dass die ungeordneten Elemente (3) durch die Bewegung des Bodens (52) aus dem ersten Aufnahmevolumen (14, 14'; 14"; 14‴: 14ʺʺ; 14‴ʺ) des ersten Aufnahmebehälters (10, 10'; 10"; 10‴, 10ʺʺ; 10‴ʺ; 100; 200) in das zweite Aufnahmevolumen (56) des zweiten Aufnahmebehälters (50) abführbar sind, und
eine erste umlaufende Außenwand (12; 212) des ersten Aufnahmebehälters (10, 10'; 10"; 10‴; 10ʺʺ; 10‴ʺ; 100; 200) angrenzend an die Auslassöffnung (16; 216) mindestens einen seitlichen Ausschnitt (32, 32'; 32"; 32‴, 32ʺʺ; 32‴ʺ) aufweist, der die Übergabezone (30) definiert, **dadurch gekennzeichnet, dass**
der seitliche Ausschnitt (32, 32'; 32"; 32‴; 32ʺʺ; 32‴ʺ) durch eine flexible Rückhaltevorrichtung zumindest teilweise blockiert ist, wodurch die ungeordneten Elemente (3) in der Übergabezone (30; 30') in einer verlangsamten Bewegung vom ersten Aufnahmebehälter (10, 10'; 10"; 10‴, 10ʺʺ; 10‴ʺ; 100; 200) an den zweiten Aufnahmebehälter (50) zugeführt werden.

2. Die Zufuhrvorrichtung (1) gemäß Patentanspruch 1, in der der Boden (52) des zweiten Aufnahmebehälters (50) mithilfe eines Antriebs in Schwingungen versetzbar ist, um die ungeordneten Elemente (3) aus dem ersten Aufnahmebehälter (10, 10': 10"; 10‴; 10ʺʺ; 10‴ʺ, 100; 200) abzuführen.

3. Die Zufuhrvorrichtung (1) gemäß Patentanspruch 1 oder 2, in der der Boden (52) des zweiten Aufnahmebehälters (50) derart beabstandet zur Auslassöffnung (16; 216) des ersten Aufnahmebehälters (10, 10'; 10"; 10‴; 10ʺʺ; 10‴ʺ; 100; 200) angeordnet ist, dass ungeordnete Elemente (3) durch den seitlichen Ausschnitt (32, 32'; 32"; 32‴; 32ʺʺ; 32‴ʺ), nicht aber durch einen Spalt zwischen der ersten Außenwand (12; 212) des ersten Aufnahmebehälters (10, 10'; 10"; 10‴, 10ʺʺ; 10‴ʺ; 100; 200) und des Bodens (52) des zweiten Aufnahmebehälters (50) abführbar sind.

4. Die Zufuhrvorrichtung (1) gemäß einem der vorhergehenden Patentansprüche, in der der seitliche Ausschnitt (32, 32'; 32"; 32"'; 32ʺʺ; 32‴ʺ) einen Öffnungswinkelbereich von 90° bis 180° bezogen auf eine Mittellängsachse des ersten Aufnahmebehälters (10, 10'; 10"; 10‴; 10ʺʺ; 10‴ʺ; 100; 200) aufweist.

5. Die Zufuhrvorrichtung (1) gemäß einem der vorhergehenden Patentansprüche, in der die flexible Rückhaltevorrichtung (40) positionsverstellbar in Bezug auf den seitlichen Ausschnitt (32, 32'; 32"; 32‴; 32ʺʺ; 32‴ʺ) des ersten Aufnahmebehälters (10, 10'; 10"; 10‴; 10ʺʺ; 10‴ʺ; 100; 200) angeordnet ist, um eine Größe einer Abdeckung des seitlichen Ausschnitts (32, 32'; 32"; 32‴; 32ʺʺ; 32‴ʺ) durch die flexible Rückhaltevorrichtung (40) zu verändern.

6. Die Zufuhrvorrichtung (1) gemäß einem der vorhergehenden Patentansprüche, in der der erste Aufnahmebehälter (10, 10'; 10"; 10‴; 10ʺʺ; 10‴ʺ; 100; 200) eine im Wesentlichen zylindrische Form aufweist und der zweite Aufnahmebehälter (50) als ein Vibrationsförderer oder ein Vibrationswendelförderer ausgebildet ist.

7. Die Zufuhrvorrichtung (1) gemäß Patentanspruch 6, in der der erste Aufnahmebehälter (10, 10'; 10"; 10‴; 10ʺʺ; 10‴ʺ; 100; 200) koaxial zum zweiten Aufnahmebehälter (50) angeordnet ist.

8. Ein Herstellungsverfahren für eine Zufuhrvorrichtung gemäß einem der Patentansprüche 1 bis 7, das die folgenden Schritte aufweist:
a. Bereitstellen (S1) eines Vibrationsförderers,
b. Bereitstellen (S2) einer Rahmenkonstruktion (20) zumindest teilweise oberhalb des Vibrationsförderers und
c. Befestigen (S3) eines ersten Aufnahmebehälters (10, 10'; 10"; 10‴, 10ʺʺ; 10‴ʺ; 100; 200) an der Rahmenkonstruktion (20), der durch eine erste umlaufende Außenwand (12; 212) ein erstes Aufnahmevolumen für die ungeordneten Elemente (3) definiert, welches über eine erste Zufuhröffnung (18; 218) in dem ersten Aufnahmebehälter (10, 10'; 10"; 10‴; 10ʺʺ; 10‴ʺ; 100; 200) befüllbar und über eine erste Auslassöffnung (16; 216) in dem ersten Aufnahmebehälter (10, 10'; 10"; 10‴, 10ʺʺ; 10‴ʺ; 100; 200) entleerbar ist, sodass eine Übergabezone (30; 30') für ungeordnete Elemente (3) von dem ersten Aufnahmebehälter (10, 10'; 10"; 10‴; 10ʺʺ; 10‴ʺ; 100; 200) in den zweiten Aufnahmebehälter (50) vorhanden ist.

9. Ein Zufuhrverfahren für eine Mehrzahl ungeordneter Elemente (3), insbesondere Verbindungselemente als Schüttgut, mithilfe einer Zufuhrvorrichtung (1) gemäß einem der Patentansprüche 1 bis 7, welches die folgenden Schritte aufweist:
a. Zuführen (Z1) einer Mehrzahl von ungeordneten Elementen (3) in das erste Aufnahmevolumen (14, 14'; 14"; 14‴; 14ʺʺ; 14‴ʺ) des ersten Aufnahmebehälters (10, 10'; 10"; 10‴; 10ʺʺ; 10‴ʺ; 100; 200),
b. Bewegen (Z2) der zweiten Innenwand (52) des zweiten Aufnahmebehälters (50) in Bezug auf den ersten Aufnahmebehälter (10, 10'; 10"; 10‴; 10""; 10‴ʺ; 100; 200), vorzugsweise Schwingen der zweiten Innenwand, und
c. Abführen (Z5) von ungeordneten Elementen (3) aus dem ersten Aufnahmebehälter (10, 10'; 10"; 10‴; 10ʺʺ; 10‴ʺ; 100; 200) über die Übergabezone (30; 30') in das zweite Aufnahmevolumen (56) des zweiten Aufnahmebehälters (50).

10. Das Zufuhrverfahren gemäß Patentanspruch 9, mit dem weiteren Schritt:
Versetzen (Z3) einer Bürstenanordnung (40), die zumindest teilweise einen seitlichen Ausschnitt (32, 32'; 32"; 32‴; 32ʺʺ; 32‴ʺ) des ersten Aufnahmebehälters (10, 10'; 10"; 10‴, 10ʺʺ; 10‴ʺ; 100; 200) verschließt.

11. Das Zufuhrverfahren gemäß Patentanspruch 10, mit dem weiteren Schritt:
Versetzen (Z4) des ersten Aufnahmebehälters (10, 10'; 10"; 10‴; 10ʺʺ; 10‴ʺ; 100; 200) in Bezug auf die zweite Innenwand (52), sodass ein Übergabespalt (30') zwischen dem ersten (10, 10'; 10"; 10‴, 10ʺʺ; 10‴ʺ; 100; 200) und dem zweiten Aufnahmebehälter (50) definiert wird.

## Claims

1. A supply device (1) with which elements (3) in unsorted form are suppliable to a second receiving volume (54), the elements (3) in unsorted form being connection elements as bulk goods and the supply device (1) having the following features:
a first receiving container (10, 10'; 10"; 10‴; 10ʺʺ; 10‴ʺ; 100; 200) having a first circumferential outer wall (12; 212) and defining a first receiving volume (14, 14'; 14"; 14‴; 14ʺʺ; 14‴ʺ) for the unsorted elements (3) which is fillable via a first supply opening (18) and drainable via a first outlet opening (16),
a second receiving container (50) having an inner wall (51) and defining the second receiving volume (56), wherein
the first receiving container (10, 10'; 10"; 10‴, 10ʺʺ; 10‴ʺ; 100; 200) with the first receiving volume (14, 14'; 14"; 14‴; 14ʺʺ; 14‴ʺ) is arranged at least partly within the second receiving volume (54),
a bottom (52) of the second receiving container (50) with a distance to the first outlet opening (16) is positioned such that the first receiving volume (14, 14'; 14"; 14‴; 14ʺʺ; 14‴ʺ) is defined and delimited by the first circumferential outer wall (12; 212) of the first receiving container (10, 10'; 10"; 10‴; 10ʺʺ; 10‴ʺ; 100; 200) and the inner wall (51) of the second receiving container (50) and a transfer zone (30, 30') is present for unsorted elements (3) from the first receiving container (10, 10'; 10"; 10‴, 10ʺʺ; 10‴ʺ; 100; 200) into the second receiving container (50), and wherein
at least the bottom (52) of the second receiving container (50) with regard to the first receiving container (10, 10'; 10"; 10‴; 10ʺʺ; 10‴ʺ; 100; 200) is movable such that the unsorted elements (3) are dischargeable from the first receiving volume (14, 14'; 14", 14‴; 14ʺʺ; 14‴ʺ) of the first receiving container (10, 10'; 10"; 10‴, 10ʺʺ; 10‴ʺ, 100; 200) into the second receiving volume (56) of the second receiving container (50) by means of the movement of the bottom (52), and
a first circumferential outer wall (12; 212) of the first receiving container (10, 10'; 10"; 10‴; 10ʺʺ; 10‴ʺ; 100; 200) includes, adjacent to the outlet opening (16; 216), at least one lateral cutout (32; 32'; 32"; 32‴, 32ʺʺ; 32‴ʺ) which defines the transfer zone (30), **characterized in that**
the lateral cutout (32; 32'; 32"; 32‴; 32ʺʺ; 32‴ʺ) is at least partly blocked by a flexible retention device, which causes the unsorted elements (3) to be supplied at a decelerated movement in the transfer zone (30; 30') from the first receiving container (10, 10'; 10"; 10‴; 10ʺʺ; 10‴ʺ; 100; 200) to the second receiving container (50).

2. The supply device (1) according to claim 1 in which the bottom (52) of the second receiving container (50) may be set into vibrations by means of a drive in order to discharge the unsorted elements (3) out of the first receiving container (10, 10'; 10"; 10‴, 10ʺʺ; 10‴ʺ; 100; 200).

3. The supply device (1) according to claim 1 or 2 in which the bottom (52) of the second receiving container (50) is arranged at such a distance to the outlet opening (16; 216) of the first receiving container (10, 10'; 10"; 10‴, 10ʺʺ; 10‴ʺ; 100; 200) that unsorted elements (3) may be discharged through the lateral cutout (32, 32'; 32"; 32‴; 32ʺʺ; 32‴ʺ), but not through a gap between the first outer wall (12; 212) of the first receiving container (10, 10'; 10"; 10‴, 10ʺʺ; 10‴ʺ; 100; 200) and the bottom (52) of the second receiving container (50).

4. The supply device (1) according to one of the preceding claims in which the lateral cutout (32, 32'; 32"; 32‴; 32ʺʺ; 32‴ʺ) comprises an opening angle range from 90° to 180° with respect to a central longitudinal axis of the first receiving container (10, 10'; 10‴; 10‴, 10ʺʺ; 10‴ʺ; 100; 200).

5. The supply device (1) according to one of the preceding claims in which the flexible retention device (40) is arranged in an adjustable manner regarding its position with respect to the lateral cutout (32, 32'; 32"; 32‴; 32ʺʺ; 32‴ʺ) of the first receiving container (10, 10'; 10ʺ; 10‴, 10ʺʺ, 10‴ʺ; 100; 200) in order to change a size of a covering of the lateral cutout (32, 32'; 32"; 32‴; 32ʺʺ; 32‴ʺ) by the flexible retention device (40).

6. The supply device (1) according to one of the preceding claims, in which the first receiving container (10, 10'; 10"; 10‴; 10ʺʺ; 10‴ʺ; 100; 200) has a generally cylindrical form and the second receiving container (50) is configured as a vibration feeder or a vibrating spiral conveyor.

7. The supply device (1) according to claim 6 in which the first receiving container (10, 10'; 10"; 10‴; 10ʺʺ; 10‴ʺ; 100; 200) is arranged coaxially to the second receiving container (50).

8. A manufacturing method for a supply device according to one of the claims 1 to 7 which includes the following steps:
a. providing (S1) a vibration feeder,
b. providing (S2) a frame construction (20) at least partly above the vibration feeder and
c. fastening (S3) a first receiving container (10, 10'; 10"; 10‴; 10ʺʺ, 10‴ʺ; 100; 200) at the frame construction (20), the container (10, 10'; 10"; 10‴; 10ʺʺ; 10‴ʺ; 100; 200) defining a first receiving volume for the unsorted elements (3) by a first circumferential outer wall (12; 212), the first receiving volume being fillable via a first supply opening (18; 218) in the first receiving container (10, 10'; 10"; 10'"; 10ʺʺ; 10‴ʺ; 100; 200) and being drainable via a first outlet opening (16; 216) in the first receiving container (10, 10'; 10"; 10‴, 10ʺʺ; 10‴ʺ; 100; 200) so that a transfer zone (30; 30') for unsorted elements (3) from the first receiving container (10, 10'; 10"; 10‴, 10ʺʺ, 10‴ʺ; 100; 200) into the second receiving container (50) is present.

9. A supply method for a plurality of unsorted elements (3), in particular connection elements as bulk goods, with the help of a supply device (1) according to one of the claims 1 to 7 which includes the following steps:
a. supplying (Z1) a plurality of unsorted elements (3) into the first receiving volume (14, 14'; 14"; 14‴; 14ʺʺ; 14‴ʺ) of the first receiving container (10, 10'; 10"; 10‴, 10ʺʺ; 10‴ʺ; 100; 200),
b. moving (Z2) the second inner wall (52) of the second receiving container (50) with respect to the first receiving container (10, 10'; 10"; 10‴, 10ʺʺ; 10‴ʺ; 100; 200), preferably vibrating the second inner wall, and
c. discharging (Z5) of unsorted elements (3) out of the first receiving container (10, 10'; 10"; 10‴; 10ʺʺ; 10‴ʺ; 100; 200) through the transfer zone (30; 30') into the second receiving volume (56) of the second receiving container (50).

10. The supply method according to claim 9 with the further step:
relocating (Z3) a brush arrangement (40) which closes at least partly a lateral cutout (32, 32'; 32"; 32‴; 32ʺʺ; 32‴ʺ) of the first receiving container (10, 10'; 10"; 10‴, 10ʺʺ; 10‴ʺ; 100; 200).

11. The supply method according to claim 10 with the further step:
relocating (Z4) the first receiving container (10, 10'; 10"; 10‴, 10ʺʺ; 10‴ʺ; 100; 200) with respect to the second inner wall (52) so that a transfer gap (30') is defined between the first (10, 10'; 10"; 10‴, 10ʺʺ, 10‴ʺ; 100; 200) and the second receiving container (50).

## Revendications

1. Dispositif d'alimentation (1) permettant d'alimenter des éléments (3) sous forme désordonnée vers un deuxième volume de réception (54), dans lequel les éléments (3) sous forme désordonnée sont des éléments d'assemblage en vrac et le dispositif d'alimentation (1) présente les caractéristiques suivantes :
un premier récipient de réception (10, 10' ; 10" ; 10‴ ; 10ʺʺ ; 10‴ʺ ; 100 ; 200), lequel présente une première paroi extérieure périphérique (12 ; 212) et définit un premier volume de réception (14, 14' ; 14" ;14‴ ; 14"" ; 14‴ʺ) pour les éléments désordonnés (3), lequel peut être rempli par le biais d'une première ouverture d'alimentation (18) et vidé par le biais d'une première ouverture de sortie (16),
un deuxième récipient de réception (50), lequel présente une paroi intérieure (51) et définit le deuxième volume de réception (56), dans lequel
le premier récipient de réception (10, 10' ; 10" ; 10‴; 10ʺʺ ; 10‴ʺ ; 100 ; 200) présentant le premier volume de réception (14, 14' ; 14" ;14‴ ; 14ʺʺ ; 14‴ʺ) est disposé au moins partiellement à l'intérieur du deuxième volume de réception (54),
un fond (52) du deuxième récipient de réception (50) est positionné à distance de la première ouverture de sortie (16), de sorte que le premier volume de réception (14, 14' ; 14" ;14‴ ; 14"" ; 14""') est défini et délimité par la première paroi extérieure périphérique (12 ; 212) du premier récipient de réception (10, 10' ; 10" ; 10‴ ; 10ʺʺ ; 10‴ʺ ; 100 ; 200) et par la paroi intérieure (51) du deuxième récipient de réception (50), et qu'il existe une zone de transfert (30, 30') pour des éléments désordonnés (3) à partir du premier récipient de réception (10, 10' ; 10" ; 10‴ ; 10ʺʺ ; 10‴ʺ ; 100 ; 200) vers le deuxième récipient de réception (50), et dans lequel
au moins le fond (52) du deuxième récipient de réception (50) est mobile de telle façon par rapport au premier récipient de réception (10, 10' ; 10" ; 10‴ ; 10ʺʺ ; 10‴ʺ ; 100 ; 200) que les éléments désordonnés (3) peuvent être évacués, par le mouvement du fond (52), hors du premier volume de réception (14, 14' ; 14" ;14‴ ; 14ʺʺ ; 14‴ʺ) du premier récipient de réception (10, 10' ; 10" ; 10‴ ; 10ʺʺ ; 10""' ; 100 ; 200) vers le deuxième volume de réception (56) du deuxième récipient de réception (50), et
une première paroi extérieure périphérique (12 ; 212) du premier récipient de réception (10, 10' ; 10" ; 10‴; 10ʺʺ; 10‴ʺ ;14‴ 100 ; 200) présente au moins une découpe latérale (32, 32' ; 32" ; 32‴; 32ʺʺ ; 32‴ʺ) adjacente à l'ouverture de sortie (16 ; 216), laquelle définit la zone de transfert (30), **caractérisé en ce que**
la découpe latérale (32, 32' ; 32" ; 32‴; 32ʺʺ ; 32""') est au moins partiellement bloquée par un dispositif de retenue souple, moyennant quoi les éléments désordonnés (3) dans la zone de transfert (30, 30') sont alimentés selon un mouvement ralenti à partir du premier récipient de réception (10, 10' ; 10" ; 10‴ ; 10ʺʺ ; 10‴ʺ ; 100 ; 200) vers le deuxième récipient de réception (50).

2. Dispositif d'alimentation (1) selon la revendication 1, dans lequel le fond (52) du deuxième récipient de réception (50) peut être mis en oscillation à l'aide d'un entraînement, afin d'évacuer les éléments désordonnés (3) hors du premier récipient de réception (10, 10' ; 10" ; 10‴ ; 10ʺʺ ; 10‴ʺ ; 100 ; 200).

3. Dispositif d'alimentation (1) selon la revendication 1 ou 2, dans lequel le fond (52) du deuxième récipient de réception (50) est disposé de telle façon à distance de l'ouverture de sortie (16 ; 216) du premier récipient de réception (10, 10' ; 10" ; 10'" ; 10ʺʺ ; 10‴ʺ ; 100 ; 200), que des éléments désordonnés (3) peuvent être évacués par le biais de la découpe latérale (32, 32' ; 32" ; 32‴; 32ʺʺ ; 32‴ʺ) et non pas par le biais d'une fente entre la première paroi extérieure (12 ; 212) du premier récipient de réception (10, 10' ; 10" ; 10‴ ; 10"" ; 10‴ʺ ;14‴ 100 ; 200) et du fond (52) du deuxième récipient de réception (50).

4. Dispositif d'alimentation (1) selon l'une des revendications précédentes, dans lequel la découpe latérale (32, 32' ; 32" ; 32‴; 32"" ; 32""') présente une plage d'angle d'ouverture de 90° à 180° par rapport à un axe longitudinal médian du premier récipient de réception (10, 10' ; 10" ; 10‴ ; 10ʺʺ ; 10‴ʺ ; 100 ; 200).

5. Dispositif d'alimentation (1) selon l'une des revendications précédentes, dans lequel le dispositif de retenue souple (40) est disposé de manière à pouvoir être réglé en position par rapport à la découpe latérale (32, 32' ; 32" ; 32‴; 32ʺʺ ; 32‴ʺ) du premier récipient de réception (10, 10' ; 10" ; 10‴; 10"" ; 10""' ; 100 ; 200), afin de modifier une taille d'un recouvrement de la découpe latérale (32, 32' ; 32" ; 32‴ ; 32ʺʺ ; 32""') par le dispositif de retenue souple (40).

6. Dispositif d'alimentation (1) selon l'une des revendications précédentes, dans lequel le premier récipient de réception (10, 10' ; 10" ; 10‴; 10ʺʺ; 10‴ʺ ; 100 ; 200) présente une forme essentiellement cylindrique et le deuxième récipient de réception (50) est conçu comme un transporteur à vibrations ou un transporteur hélicoïdal à vibrations.

7. Dispositif d'alimentation (1) selon la revendication 6, dans lequel le premier récipient de réception (10, 10' ; 10" ; 10‴ ; 10ʺʺ ; 10‴ʺ ; 100 ; 200) est disposé de façon coaxiale par rapport au deuxième récipient de réception (50).

8. Procédé de fabrication pour un dispositif d'alimentation selon l'une des revendications 1 à 7, lequel présente les étapes suivantes :
a. mise à disposition (S1) d'un transporteur à vibrations,
b. mise à disposition (S2) d'une structure de cadre (20) au moins partiellement au-dessus du transporteur à vibrations et
c. fixation (S3) d'un premier récipient de réception (10, 10' ; 10" ; 10‴ ; 10ʺʺ ; 10‴ʺ ; 100 ; 200) à la structure de cadre (20), lequel définit un premier volume de réception pour les éléments désordonnés (3) par une première paroi extérieure périphérique (12 ; 212), lequel peut être rempli par le biais d'une première ouverture d'alimentation (18 ; 218) dans le premier récipient de réception (10, 10' ; 10" ; 10‴ ; 10ʺʺ ; 10‴ʺ ; 100 ; 200) et vidé par le biais d'une première ouverture de sortie (16 ; 216) dans le premier récipient de réception (10, 10' ; 10" ; 10‴; 10ʺʺ, 10‴ʺ ; 100 ; 200), de sorte qu'il existe une zone de transfert (30 ; 30') pour des éléments désordonnés (3) à partir du premier récipient de réception (10, 10' ; 10" ; 10‴ ; 10ʺʺ ; 10‴ʺ ; 100 ; 200) vers le deuxième récipient de réception (50).

9. Procédé d'alimentation pour une pluralité d'éléments désordonnés (3), en particulier d'éléments d'assemblage en vrac, à l'aide d'un dispositif d'alimentation (1) selon l'une des revendications 1 à 7, lequel présente les étapes suivantes :
a. alimentation (Z1) d'une pluralité d'éléments désordonnés (3) vers le premier volume de réception (14, 14' ; 14" ;14'" ; 14ʺʺ ; 14‴ʺ) du premier récipient de réception (10, 10' ; 10" ; 10‴ ; 10ʺʺ ; 10""' ; 100 ; 200),
b. mise en mouvement (Z2) de la deuxième paroi intérieure (52) du deuxième récipient de réception (50) par rapport au premier récipient de réception (10, 10' ; 10" ; 10‴ ; 10ʺʺ ; 10‴ʺ ; 100 ; 200), de préférence oscillation de la deuxième paroi intérieure, et
c. évacuation (Z5) d'éléments désordonnés (3) hors du premier récipient de réception (10, 10' ; 10" ; 10‴ ; 10"" ; 10‴ʺ ; 100 ; 200) par le biais de la zone de transfert (30, 30') vers le deuxième volume de réception (56) du deuxième récipient de réception (50).

10. Procédé d'alimentation selon la revendication 9, comprenant l'étape supplémentaire suivante :
déplacement (Z3) d'un ensemble de brosse (40), lequel ferme au moins partiellement une découpe latérale (32, 32' ; 32" ; 32‴ ; 32ʺʺ ; 32‴ʺ) du premier récipient de réception (10, 10' ; 10" ; 10‴ ; 10ʺʺ ; 10‴ʺ ; 100 ; 200).

11. Procédé d'alimentation selon la revendication 10, comprenant l'étape supplémentaire suivante :
déplacement (Z4) du premier récipient de réception (10, 10' ; 10" ; 10'" ; 10ʺʺ ; 10""' ; 100 ; 200) par rapport à la deuxième paroi intérieure (52), de manière à définir une fente de transition (30') entre le premier (10, 10' ; 10" ; 10‴ ; 10ʺʺ ; 10‴ʺ ; 100 ; 200) et le deuxième récipient de réception (50).
